# EUROPEAN PATENT SPECIFICATION

(11) **EP 2 547 735 B1**
(45) Date of publication and mention of the grant of the patent: **16.03.2016**
(21) Application number: 10711782.2
(22) Date of filing: 19.03.2010
(51) Int. Cl.: C09D 5/24, H01B 1/22, H01L 31/0224

(54) **ANTI-CORROSION AGENTS FOR TRANSPARENT CONDUCTIVE FILM**
ANTIKORROSIONSMITTEL FÜR EINE TRANSPARENTE LEITENDE FOLIE
AGENTS ANTICORROSION POUR FILM CONDUCTEUR TRANSPARENT

(43) Date of publication of application: 23.01.2013
(73) Proprietor: Carestream Health, Inc., Rochester, New York 14608 (US)
(72) Inventor: ZOU, Chaofeng, Maplewood Minnesota 55119 (US); RAMSDEN, William, Afton, Minnesota 55001 (US)
(74) Representative: Klang, Alexander H.
(86) International application number: PCT/US2010/000823
(87) International publication number: WO 2011/115603

(56) References cited:
- WO-A2-2007/022226
- US-A1- 2007 074 316
- US-A1- 2008 286 447

## Description

### FIELD OF THE INVENTION

This invention relates to anti-corrosion agents for transparent electrically conductive films comprising silver nanowire random networks and a polymer binder, and to methods of manufacturing and using films containing these anti-corrosion agents.

### BACKGROUND OF THE INVENTION

Transparent and conductive films (TCF) have been used extensively in recent years in applications such as touch panel displays, liquid crystal displays, electroluminescent lighting, organic light-emitting diode devices, and photovoltaic solar cells. Indium tin oxide (ITO) based transparent conductive film has been the transparent conductor-of-choice for most applications until recently due to its high conductivity, transparency, and relatively good stability. However, indium tin oxide based transparent conductive films have limitations due to the high cost of indium, the need for complicated and expensive vacuum deposition equipment and processes, and indium tin oxide's inherent brittleness and tendency to crack, especially when it is deposited on flexible substrates.

Two of the most important parameters for measuring the properties of transparent conductive films are total light transmittance (%T) and film surface electric conductivity. Higher light transmittance allows clear picture quality for display applications, higher efficiency for lighting and solar energy conversion applications. Lower resistivity is most desirable for most transparent conductive films applications in which power consumption can be minimized. Therefore, the higher the T/R ratio of the transparent conductive films is, the better the transparent conductive films are.

U.S. Patent Application Publication 2006/0257638A1 describes a transparent conductive film comprising carbon nanotubes (CNT) and vinyl chloride resin polymer binder.

U.S. Patent Application Publications 2007/0074316A1 and 2008/0286447A1 describe a transparent conductive film in which silver nanowires are deposited onto a substrate to form a bare nanowire network followed by overcoating the silver nanowire network with a polymer matrix material to form a transparent conductive film. This requires the difficult process of coating silver nanowires in solution containing only surfactant and solvent. The polymer materials such as polyacrylates and carboxyl alkyl cellulose polymers were suggested as useful materials for the matrix.

U.S. Patent Application Publication 2008/0292979 describes a transparent conductive film comprising silver nanowires, or a mixture of silver nanowires and carbon nanotubes. The transparent conductive network is formed either without polymer binder or in a photoimageable composition. The transparent and conductive films were coated on both glass and polyethylene terephthalate (PET) supports.

U.S. Patent Application Publication 2009/0130433A1 describes a transparent conductive film which is formed from coating of silver nanowires to form a network followed by overcoating with a layer of urethane acrylate polymer binder.

### Problem to be Solved:

In order for silver based transparent conductors to have practical use it is important that these silver based transparent conductors be stable for a long period when subjected to environmental conditions.

Any atmospheric corrosion due to the reaction of low levels of chemicals in the air will induce undesirable chemical reactions at the metal nanowire surface, impacting the conductivity and performance of the metal nanowire based transparent conductors. It is well known that corrosion, or "tarnishing", readily occurs on silver metal surfaces when exposed to the atmosphere, due to sulfidation of silver surface from reaction of hydrogen sulfide with silver:

2Ag + H₂S → Ag₂S + H₂

Because the electric conductivity of silver sulfide is much lower than that of silver metal, silver nanowire based conductors can gradually lose conductivity when exposed to the atmosphere.

In contrast to bare metal wires exposed to the air, silver nanowires in a polymer matrix are more stable since the presence of the polymer slows down the diffusion of hydrogen sulfide (or other corrosive agents) to the silver nanowire surface. Nevertheless, it is important to stabilize the silver nanowire surface to prevent the sulfidization process, even when the nanowires are embedded in a polymer matrix.

US Patent Application Publication 2008/0286447 suggests the use of aromatic triazoles and other nitrogen containing compounds as corrosion inhibitors for silver nanowire based transparent conductors. Long chain alkylthio compounds have also been suggested as useful corrosion inhibitors.

It would be useful to find anti-corrosion agents for transparent electrically conductive films comprising a random network of silver nanowires in polymer binder(s) that can be coated from aqueous or from organic solvents, using common coating techniques.

### SUMMARY OF THE INVENTION

We have found that certain 1,2-diazine compounds are particularly useful as anti-corrosion agents for the stabilization of a random network of silver nanowire-based transparent conductive films toward the undesirable reaction of such conductive films with corrosive agents such as hydrogen sulfide.

In one embodiment, the invention provides a transparent conductive article comprising:
a transparent support having coated thereon;
a transparent conductive film comprising a random network of silver nanowires dispersed within a polymer binder; and
one or more 1,2-diazine compounds having the general structure (I) or (II); 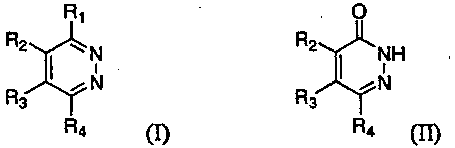 wherein R₁, R₂, R₃, and R₄ are independently: hydrogen, a substituted or unsubstituted alkyl group comprising up to 20 carbon atoms, a substituted or unsubstituted aryl group comprising up to 10 carbon atoms, a substituted or unsubstituted heteroaryl group comprising up to 10 carbon, oxygen, nitrogen, or sulfur atoms, a halogen atom (F, Cl, Br, or I), a hydroxyl group (OH), a thiol group (SH), a substituted or unsubstituted alkoxy group comprising up to 20 carbon atoms, an amino group (NR₅R₆) where R₅ and R₆ are independently a hydrogen, an alkyl group comprising up to 20 carbon atoms, or an aryl group comprising up to 10 carbon atoms, a thioether group (SR₇) where R₇ is an alkyl group comprising up to 20 carbon atoms, or an aryl group comprising up to 10 carbon atoms, a sulfoxy group (SOR₇), a sulfone group (SO₂R₇), a carboxylic acid group (COOH) or a salt of a carboxylic acid (CO₂⁻ M⁺) where M⁺ is a cation (such as a metal cation, a quaternary ammonium cation or a quaternary phosphonium cation), a carboxamide group (CONR₅R₆), an acylamino group (NR₅COR₇), an acyl group (COR₇), an acyloxy group (OCOR₇), or a sulfonamido group (SO₂NR₅R₆),
   or (R₁ and R₂) or (R₂ and R₃) or (R₃ and R₄) are joined together with 1 to 5 carbon, nitrogen, sulfur, and/or oxygen atoms to form an alicylic or aromatic ring(s).

In another embodiment, the invention provides a transparent conductive article comprising:
a transparent polyethylene terephthalate support having coated thereon;
a transparent conductive film comprising a random network of silver nanowires having an aspect ratio of from 20 to 3300 dispersed within a polymer binder in an amount sufficient to provide a surface resistivity of 500 ohm/sq or less and a transmittance of at least 70% across the entire spectrum range of from 350 nm to 1100 nm; and
a 1,2-diazine compound represented by one or more of the structures: 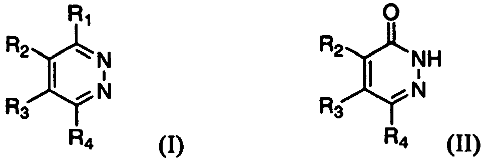 wherein R₁, R₂, R₃, and R₄ are as described above.

In a further embodiment, the invention further provides a process for the formation of a transparent conductive article comprising:
preparing a dispersion of silver nanowires in a solution of a 1,2-diazine compound and polymer binder;
wherein the 1,2-diazine compound has the general structure (I) or (II); 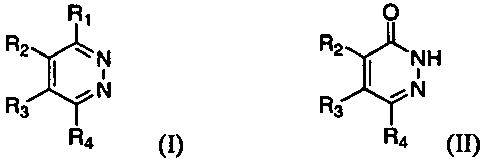 wherein R₁, R₂, R₃, and R₄ are as described above.
coating, the dispersion of silver nanowires in the solution of 1,2-diazine compound and polymer binder onto a transparent support; and
drying the coating on the support thereby forming a random network of silver nanowires.

### DETAILED DESCRIPTION OF THE INVENTION

### Definitions:

The terms "conductive layer" or "conductive film" refer to the network layer comprising silver nanowires dispersed within a polymer binder.

The term "conductive" refers to electrical conductivity.

The term "article" refers to the coating of a "conductive layer" or "conductive film" on a support.

The terms "coating weight", "coat weight", and "coverage" are synonymous, and are usually expressed in weight or moles per unit area such as g/m² or mol/m².

The term "transparent" means capable of transmitting visible light without appreciable scattering or absorption.

"Haze" is wide-angle scattering that diffuses light uniformly in all directions. It is the percentage of transmitted light that deviates from the incident beam by more than 2.5 degrees on the average. Haze reduces contrast and results in a milky or cloudy appearance. The lower the haze number, the less hazy the material.

The term "organic solvent" means "a material, liquid at use temperature, whose chemical formula comprises one or more carbon atoms".

The term "aqueous solvent" means a material, liquid at use temperature, whose composition in a homogeneous solution comprises water in the greatest proportion (i.e., at least 50 per cent water by weight).

The term "water soluble" means the solute forms a homogenous solution with water, or a solvent mixture in which water is the major component.

The terms "a" or "an" refer to "at least one" of that component (for example, the anti-corrosion agents, nanowires, and polymers described herein).

Furthermore, all publications, patents, and patent documents referred to in this document are incorporated by reference herein in their entirety, as though individually incorporated by reference.

### The Silver Nanowires:

The silver nanowires are an essential component for imparting electrical conductivity to the conductive films, and to the articles prepared using the conductive films. The electrical conductivity of the transparent conductive film is mainly controlled by a) the conductivity of a single nanowire, b) the number of nanowires between the terminals, and c) the connectivity between the nanowires. Below a certain nanowire concentration (also referred as the percolation threshold), the conductivity between the terminals is zero, as there is no continuous current path provided because the nanowires are spaced too far apart. Above this concentration, there is at least one current path available. As more current paths are provided, the overall resistance of the layer will decrease. However, as more current paths are provided, the clarity (i.e., percent light transmission) of the conductive film decreases due to light absorption by the nanowires. Also, as the amount of silver nanowires in the conductive film increases, the haze of the transparent film increases due to light scattering by the silver nanowires. Similar effects will occur in transparent articles prepared using the conductive films.

In one embodiment, the silver nanowires have aspect ratio (length/width) of from 20 to 3300. In another embodiment, the silver nanowires have an aspect ratio (length/width) of from 500 to 1000. Silver nanowires having a length of from 5 µm to 100 µm (micrometer) and a width of from 30 nm to 200 nm are useful. Silver nanowires having a width of from 50 nm to 120 nm and a length of from 15 µm to 100 µm are also useful for construction of a transparent conductive network film.

Silver nanowires can be prepared by known methods in the art. In particular, silver nanowires can be synthesized through solution-phase reduction of a silver salt (e.g., silver nitrate) in the presence of a polyol (e.g., ethylene glycol or propylene glycol) and poly(vinyl pyrrolidone). Large-scale production of silver nanowires of uniform size can be prepared according to the methods described in, e.g., Ducamp-Sanguesa, C. et al, J. of Solid State Chemistry, (1992), 100, 272-280; Xia, Y et al., Chem. Mater. (2002), 14, 4736-4745, and Xia, Y. et al., Nano Letters, (2003), 3(7), 955-960.

### The Polymer Binder:

For a practical manufacturing process for transparent conductive films, it is important to have both the conductive components, such as silver nanowires, and a polymer binder in a coating solution. The polymer binder solution serves a dual role, as dispersant to facilitate the dispersion of silver nanowires and as a viscosifier to stabilize the silver nanowire coating dispersion so that the sedimentation of silver nanowires does not occur at any point during the coating process. It is also desirable to have the silver nanowires and the polymer binder in a single coating dispersion. This simplifies the coating process and allows for a one-pass coating, and avoids the method of first coating bare silver nanowires to form a weak and fragile film that is subsequently over-coated with a polymer to form the transparent conductive film.

In order for a transparent conductive film to be useful in various device applications, it is also important for the polymer binder of the transparent conductive film to be optically transparent and flexible, yet have high mechanical strength, good hardness, high thermal stability and light stability. This requires polymer binders to be used for transparent conductive film to have Tg (glass transition temperature) greater than the use temperature of the transparent conductive film.

Transparent, optically clear polymer binders are known in the art. Examples of suitable polymeric binders include, but are not limited to: polyacrylics such as polymethacrylates (e.g., poly(methyl methacrylate)), polyacrylates and polyacrylonitriles, polyvinyl alcohols, polyesters (e.g., polyethylene terephthalate (PET), polybutylene terephthalate, and polyethylene naphthalate), polymers with a high degree of aromaticity such as phenolics or cresol-formaldehyde (Novolacs®), polystyrenes, polyvinyltoluene, polyvinylxylene, polyimides, polyamides, polyamideimides, polyetheramides, polysulfides, polysulfones, polyphenylenes, and polyphenyl ethers, polyurethane (PU), polycarbonates, epoxy, polyolefins (e.g. polypropylene, polymethylpentene, and cyclic olefins), acrylonitrile-butadiene-styrene copolymer (ABS), cellulosics, silicones and other silicon-containing polymers (e.g. polysilsesquioxanes and polysilanes), polyvinylchloride (PVC), polyvinylacetates, polynorbomenes, synthetic rubbers (e.g. EPR, SBR, EPDM), and fluoropolymers (e.g., polyvinylidene fluoride, polytetrafluoroethylene (TFE) or polyhexafluoropropylene), copolymers of fluoro-olefin and hydrocarbon olefin (e.g., Lumiflon®), and amorphous fluorocarbon polymers or copolymers (e.g., CYTOP® by Asahi Glass Co., or Teflon® AF by Du Pont), polyvinylbutryals, polyvinylacetals, gelatins, polysaccharides, and starches.

In certain embodiments, in order to disperse and stabilize silver nanowires in polymeric coating solution, the use of polymer binders having a high oxygen content is advantageous. Oxygen-containing groups, such as hydroxyl group and carboxylate groups have a strong affinity for binding to the silver nanowire surface and facilitate the dispersion and stabilization. Many oxygen-rich polymers also have good solubility in the polar organic solvents commonly used to prepare organic solvent-coated materials, while other oxygen-rich polymers have good solubility in water or the aqueous solvent mixtures commonly used to prepare aqueous solvent-coated materials.

In certain embodiments, cellulose ester polymers, such as cellulose acetate butyrate (CAB), cellulose acetate (CA), or cellulose acetate propionate (CAP) are superior to other oxygen-rich polymer binders when used to prepare silver nanowire based transparent conductive films that are coated from organic solvents such as 2-butanone (methyl ethyl ketone, MEK), methyl iso-butyl ketone, acetone, methanol, ethanol, 2-propanol, ethyl acetate, or mixtures thereof. Their use results in transparent conductive films in which both the optical light transmittance and electrical conductivity of the coated films are greatly improved. In addition, these cellulose ester polymers have glass transition temperatures of at least 100°C and provide transparent, flexible films having high mechanical strength, good hardness, high thermal stability, and light stability.

The cellulose ester polymers can be present in from 40 to 90 wt% of the dried transparent conductive films. Preferably, they are present in from 60 to 85 wt% of the dried films. In some constructions, a mixture of a cellulosic ester polymer and one or more additional polymers may be used. These polymers should be compatible with the cellulosic polymer. By compatible is meant that the polymers form a transparent, single phase mixture when dried. The additional polymer or polymers can provide further benefits such as promoting adhesion to the support and improving hardness and scratch resistance. As above, total wt% of all polymers is from 40 to 95 wt% of the dried transparent conductive films. Preferably, the total weight of all polymers is from 60 to 85 wt% of the dried films. Polyester polymers are examples of useful additional polymers.

In other embodiments, water soluble polymer binders can also be used, such as polyvinyl alcohol, gelatin, polyacrylic acid, polyimides. Other water dispersible latex polymers can also be used such as polyacrylates and polymethacrylates containing (meth)acrylic acid units. Coating from aqueous solutions benefits the environment and reduces the emission of volatile organic compounds during manufacturing.

The use of water soluble polymers, such as polyvinyl alcohol or gelatin as binders for silver nanowire based transparent conductors results in superior transparent conductive films in which both film transmittance and conductivity are greatly improved. Similar transparent conductive films prepared using aqueous dispersions of a polyurethane polymer binder show less desirable transmittance and conductivity. Transparent conductive films prepared using either polyvinyl alcohol or gelatin polymer binders also show excellent clarity, scratch resistance, and hardness when polymer cross linkers are added to the polymer solution. Transparent conductive films prepared according to this invention provide transmittance of at least 70% across entire spectrum range of 350 nm to 1100 nm, and surface resistivity of 500 ohm/sq or less.

The transparent conductive articles comprising silver nanowires and water soluble polymer binders also show excellent clarity, high scratch resistance and hardness. In addition, transparent conductive films prepared using these polymer binders have good adhesion on a polyethylene terephthalate (PET) support when the polyester supported is pre-coated with a gelatin subbing layer.

The water soluble polymer binders are present in from 40 to 95 wt% of the dried transparent conductive films. Preferably, they are present in from 60 to 85 wt% of the dried films.

In some constructions, up to 50 wt% of the gelatin or polyvinyl alcohol polymer binder can be replaced by one or more additional polymers. These polymers should be compatible with the gelatin or polyvinyl alcohol polymer binder. By compatible is meant that the all polymers form a transparent, single phase mixture when dried. The additional polymer or polymers can provide further benefits such as promoting adhesion to the support and improving hardness and scratch resistance. Water soluble acrylic polymers are particularly preferred as additional polymers. Examples of such polymers are polyacrylic acid and polyacrylamides, and copolymers thereof. As above, total wt% of all polymers is from 50 to 95 wt% of the dried transparent conductive films. Preferably, the total weight of all polymers is from 70 to 85 wt% of the dried films.

If desired, scratch resistance and hardness of the transparent conductive films with these polymer binders to the support can be improved by use of crosslinking agents to crosslink the polymer binders. Isocyanates are examples of typical crosslinking agents for cellulose ester polymers containing free hydroxyl groups. Vinyl sulfones are examples of typical crosslinking agents for gelatin binders.

### Anticorrosion Agents:

Anti-corrosion agents are chemical compounds that, when added to the transparent conductive film, improve the stability of the construction with respect to atmospheric corrosion caused by the reaction of one or more chemicals in the atmosphere with one or more components in the film. This reaction results in deterioration of the electric conductivity and/or physical integrity of the film. Anti-corrosion agents should be colorless and odorless when used in the transparent conductive film, and should be stable to the conditions of heat, light, and humidity in the environment where transparent conductive film is used.

For a silver nanowire based conductive film, chemical compounds with functional group containing N, O, or S are potentially useful anticorrosion agents due to coordinating ability of these functional groups to the silver nanowire surfaces. Coordination is thought to complex with these compounds and passivate the silver surface to prevent the reaction of atmosphere gases with the silver surface. However, in practice, many such compounds, when bound to a silver nanowire surface, will drastically reduce the electric conductivity of the resultant conductive film. Apparently, the insulating effect of these compounds prevents electron "flow" at nanowire contact points. Therefore, it is important to identify a class of compounds that will provide anti-corrosion protection to transparent conductive film without causing significant reduction in conductivity and other negative effects.

We have found that 1,2-diazine compounds provide anti-corrosion properties when incorporated into silver nanowire containing films. The 1,2-diazine compounds have the general structure (I) or (II). 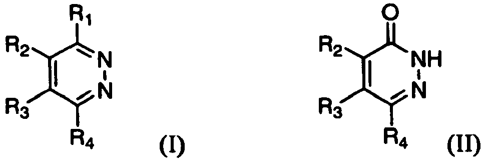 wherein R₁, R₂, R₃, and R₄ are independently: hydrogen, a substituted or unsubstituted alkyl group comprising up to 20 carbon atoms, a substituted or unsubstituted aryl group comprising up to 10 carbon atoms, a substituted or unsubstituted heteroaryl group comprising up to 10 carbon, oxygen, nitrogen, or sulfur atoms, a halogen atom (F, Cl, Br, or I), a hydroxyl group (OH), a thiol group (SH), a substituted or unsubstituted alkoxy group comprising up to 20 carbon atoms, an amino group (NR₅R₆) where R₅ and R₆ are independently a hydrogen, an alkyl group comprising up to 20 carbon atoms, or an aryl group comprising up to 10 carbon atoms, a thioether group (SR₇) where R₇ is an alkyl group comprising up to 20 carbon atoms, or an aryl group comprising up to 10 carbon atoms, a sulfoxy group (SOR₇), a sulfone group (SO₂R₇), a carboxylic acid group (COOH) or a salt of a carboxylic acid (CO₂⁻ M⁺) where M⁺ is a cation (metal ion or quaternary ammonium or quaternary phosphonium ion), a carboxamide group (CONR₅R₆), an acylamino group (NR₅COR₇), an acyl group (COR₇), an acyloxy group (OCOR₇), or a sulfonamido group (SO₂NR₅R₆),
or (R₁ and R₂) or (R₂ and R₃) or (R₃ and R₄) are joined together with 1 to 5 carbon, nitrogen, sulfur, and/or oxygen atoms to form an alicylic or aromatic ring(s).

In another embodiment, R₁, R₂, R₃, and R₄ are hydrogen, halogen, hydroxyl, alkyl groups comprising 1 to 6 carbon atoms, aryl groups comprising 6 carbon atoms, alkoxy groups comprising 1 to 6 carbon atoms, or (R₁ and R₂) or (R₂ and R₃) or (R₃ and R₄) are joined together with 4 carbon atoms to form a fused benzo ring.

In another embodiment, R₁, R₂, R₃, and R₄ are hydrogen, chloro, bromo, hydroxyl, alkyl groups comprising 1 to 4 carbon atoms, aryl groups comprising 6 carbon atoms, alkoxy groups comprising 1 to 4 carbon atoms, or (R₂ and R₃) are joined together with 4 carbon atoms to form a fused benzo ring.

Examples of 1,2-diazine compounds having structures (I) and (II) include:

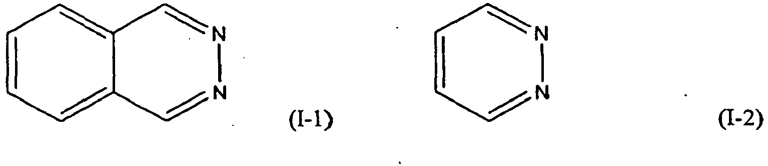

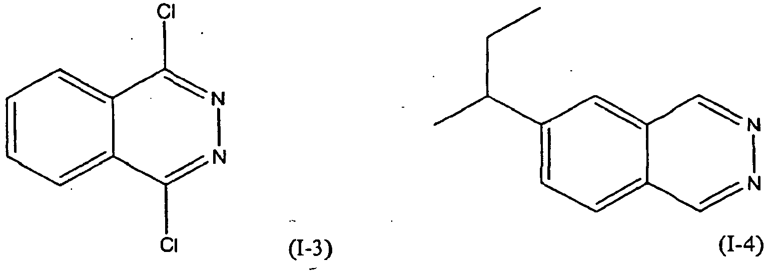

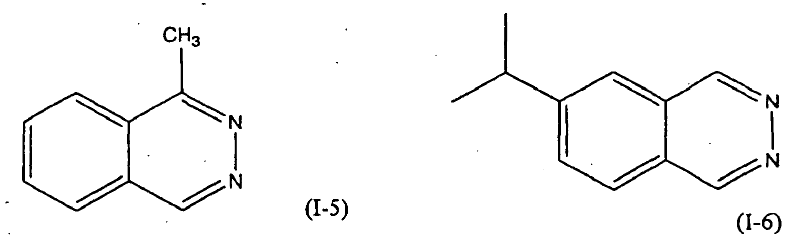

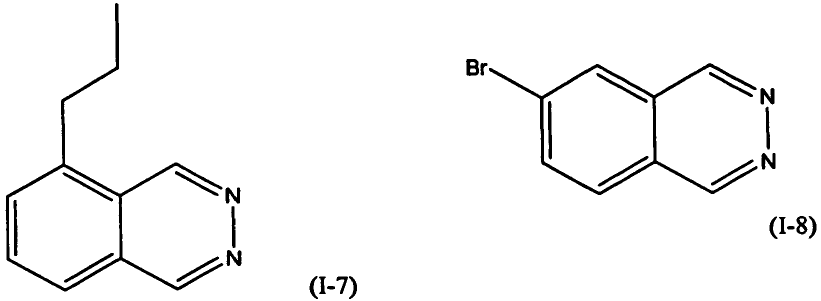

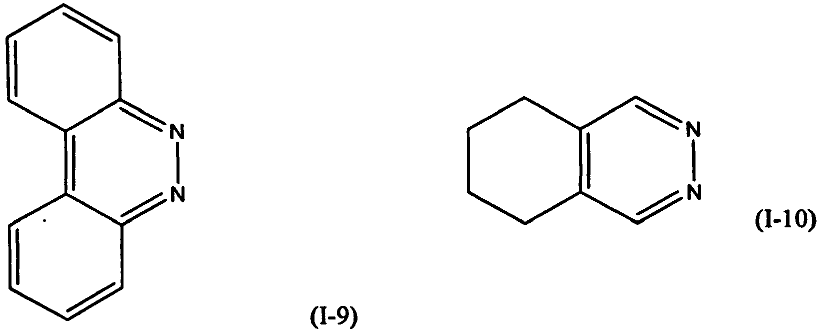

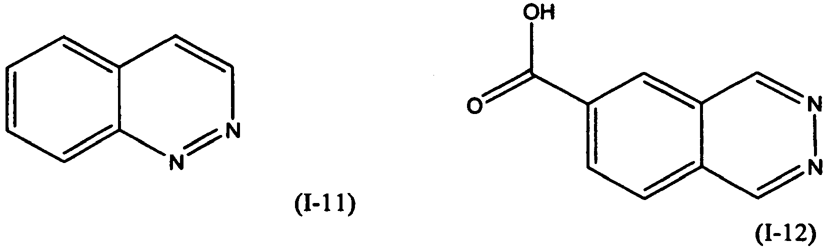

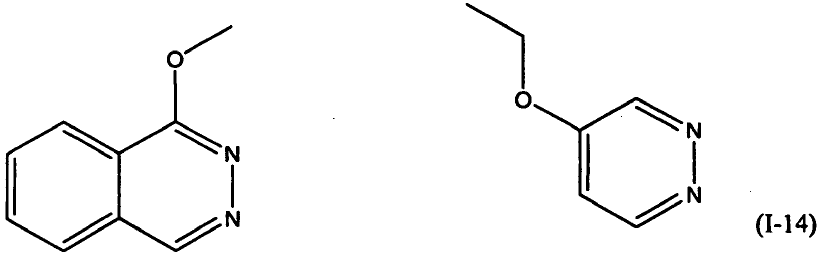

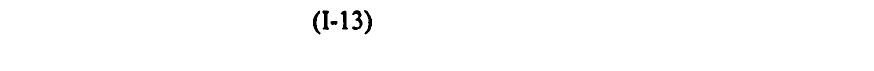

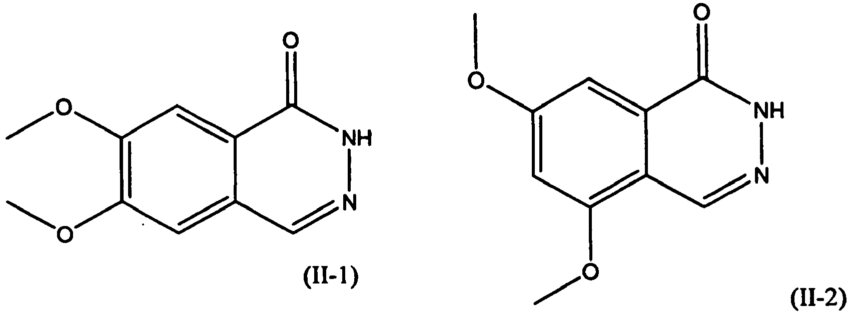

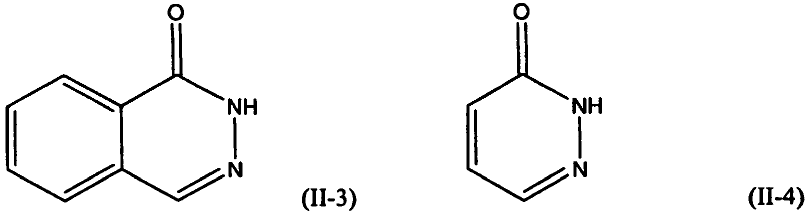

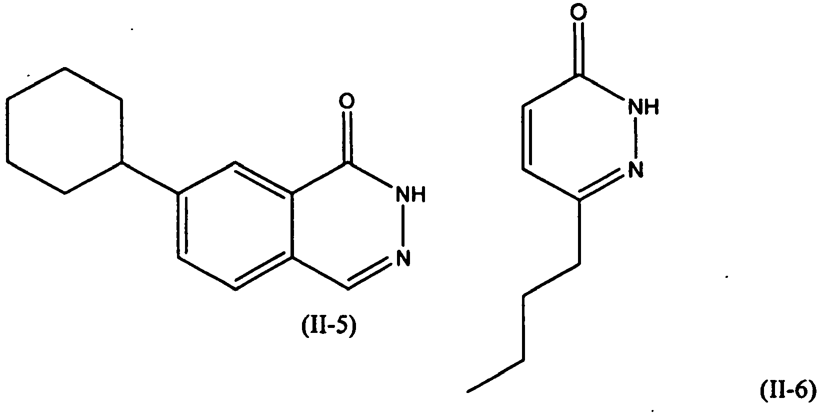

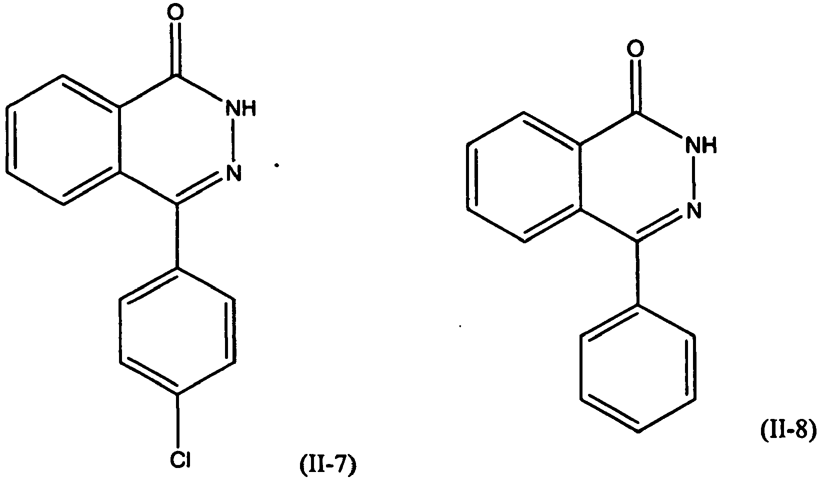

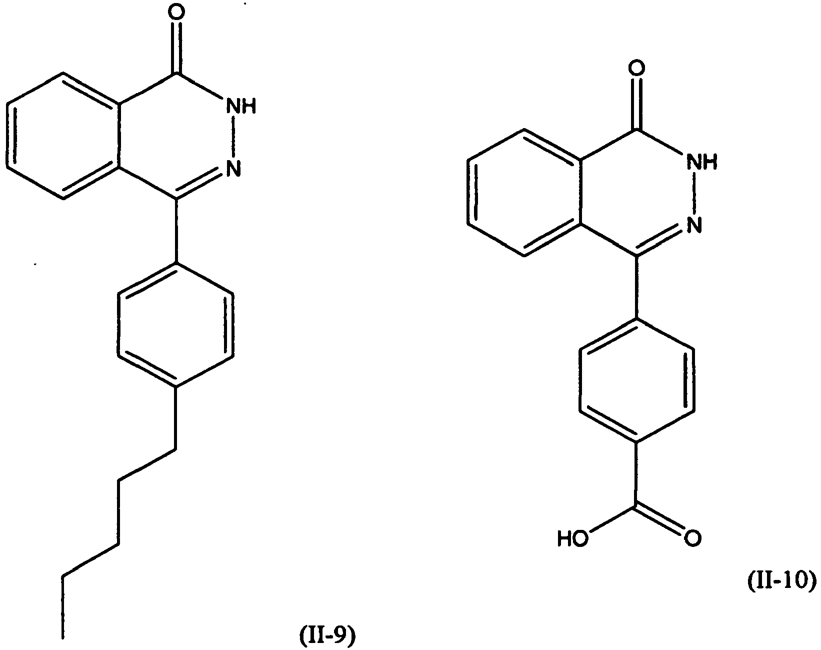

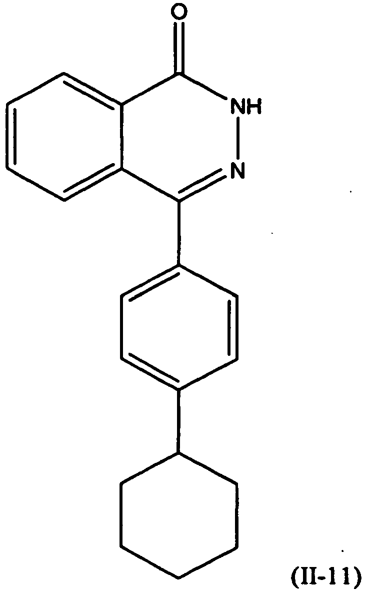

### Coating of the Conductive Films:

An organic solvent-based coating formulation for the transparent silver nanowire films can be prepared by mixing the various components with one or more polymer binders in a suitable organic solvent system that usually includes one or more solvents such as toluene, 2-butanone (methyl ethyl ketone, MEK), methyl iso-butyl ketone, acetone, methanol, ethanol, 2-propanol, ethyl acetate, ethyl lactate, tetrahydrofuran, or mixtures thereof. Methyl ethyl ketone is a particularly useful coating solvent. An aqueous-based coating formulation for the transparent silver nanowire films can be prepared by mixing the various components with one or more polymer binders in water or in a mixture of water with a water miscible solvent such as acetone, methanol, ethanol, 2-propanol, or tetrahydrofuran, or mixtures thereof. Transparent films containing silver nanowires can be prepared by coating the formulations using various coating procedures such as wire wound rod coating, dip coating, air knife coating, curtain coating, slide coating, slot-die coating, roll coating, gravure coating, or extrusion coating. Surfactants and other coating aids can be incorporated into the coating formulation.

In one embodiment the coating weight of the silver nanowires is from 20 mg/m² to 500 mg/m². In another embodiment the coating weight of silver nanowires is from 20 mg/m² to 200 mg/m². In a further embodiment, the coating weight of silver nanowires is from 30 mg/m² to 120 mg/m². A useful coating dry thickness of the transparent conductive coating is from 0.05 µm to 2.0 µm, and preferably from 0.1 µm to 0.5 µm.

Upon coating and drying, the transparent conductive film should have a surface resistivity of less than 1,000 ohms/sq and preferably less than 500 ohm/sq.

Upon coating, and drying, the transparent conductive film should have as high a % transmittance as possible. A transmittance of at least 70% is useful. A transmittance of at least 80% and even at least 90% are even more useful.

Particularly useful are films with a transmittance of at least 70% and a surface resistivity of less than 500 ohm/sq.

The transparent conductive films according this invention provide transmittance of at least 70% across entire spectrum range of from 350 nm to 1100 nm, and surface resistivity of less than 500 ohm/sq.

### The Transparent Support:

In one embodiment, the conductive materials are coated onto a support. The support may be rigid or flexible.

Suitable rigid substrates include, for example, glass, polycarbonates, acrylics, and the like.

When the conductive materials are coated onto a flexible support, the support is preferably a flexible, transparent polymeric film that has any desired thickness and is composed of one or more polymeric materials. The support is required to exhibit dimensional stability during coating and drying of the conductive layer and to have suitable adhesive properties with overlying layers. Useful polymeric materials for making such supports include polyesters [such as poly(ethylene terephthalate) (PET) and poly(ethylene naphthalate) (PEN)], cellulose acetate and other cellulose esters, polyvinyl acetal, polyolefins, polycarbonates, and polystyrenes. Preferred supports are composed of polymers having good heat stability, such as polyesters and polycarbonates. Support materials may also be treated or annealed to reduce shrinkage and promote dimensional stability. Transparent multilayer supports can also be used.

### Coating of the Conductive Films onto a Support:

Transparent conductive articles can be prepared by coating the formulations described above onto a transparent support using various coating procedures such as wire wound rod coating, dip coating, air knife coating, curtain coating, slide coating, slot-die coating, roll coating, gravure coating, or extrusion coating.

Alternatively, transparent conductive articles can be prepared by laminating the transparent conductive films prepared as described above onto a transparent support.

In some embodiments, a "carrier" layer formulation comprising a single-phase mixture of two or more polymers may be applied directly onto the support and thereby located between the support and the silver nanowire layer. The carrier layer serves to promote adhesion of the support to the transparent polymer layer containing the silver nanowires. The carrier layer formulation can be sequentially or simultaneously applied with application of the transparent conductive silver nanowire layer formulation. It is preferred that all coating be applied simultaneously onto the support. Carrier layers are often referred to as "adhesion promoting layers", "interlayers", or "intermediate layers".

As noted above, in one embodiment the coating weight of the silver nanowires is from 20 mg/m² to 500 mg/m². In other embodiments, coating weight of silver nanowires is from 20 mg/m² to 200 mg/m². Embodiments wherein the silver nanowires are coated at from 30 mg/m² to 120 mg/m² are also contemplated.

Upon coating and drying, the transparent conductive article should have a surface resistivity of less than 1,000 ohms/sq and preferably less than 500 ohm/sq.

Similarly, upon coating and drying on a transparent support, the transparent conductive article should have as high an optical transmittance as possible. A transmittance of at least 70% is useful. A transmittance of at least 80% and even at least 90% are even more useful.

Particularly preferred are articles with a transmittance of at least 70% and a surface resistivity of less than 500 ohm/sq.

The following examples are provided to illustrate the practice of the present invention and the invention is not meant to be limited thereby.

### Materials and Methods for the Experiments and Examples:

All materials used in the following examples are readily available from standard commercial sources, such as Aldrich Chemical Co. (Milwaukee, Wisconsin) unless otherwise specified. All percentages are by weight unless otherwise indicated. The following additional methods and materials were used.

Bismuth neodecanoate is the bismuth salt of neodecanoic acid.

CAB 171-15 is a cellulose acetate butyrate resin available from Eastman Chemical Co. (Kingsport, TN). It has a glass transition temperature of 161°C.

Mayer Bars are 1/2 inch diameter Type 303 stainless steel coating rods and are available from R.D. Specialties, Inc. (Webster, NY).

MEK is methyl ethyl ketone (or 2-butanone).

Silver nanowires were prepared according to literature procedures (Wiley, B.; Sun, Y.; Xia, Y. *Langmuir,* 21, (18), 8077, 2005). Silver nanowires prepared showed diameters ranging from 80 to 140 nm, and length ranging from 10 to 50 µm.

THDI is Desmodur N-3300 (2,2,4-trimethylhexamethylene diisocyanate). It is the trimer of hexamethylene diisocyanate and is available from Bayer Material Science (Pittsburgh, PA).

BHTT is 4-Benzyl-1,2,4-triazole-3-thiol. It has structure (C-1) shown below.

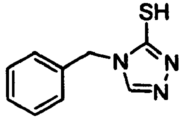

BZT is benzotriazole. It has structure (C-2) shown below.

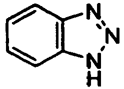

MMBI is 2-mercapto-4(5)-methylbenzimidazole. It has structure (C-3) shown below.

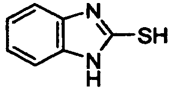

4-MPA is 4-Methylphthalic acid. It has structure (C-4) shown below.

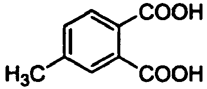

PMT is 1-Phenyl-1H-tetrazole-5-thiol (phenyl-mercapto-tetrazole). It has structure (C-5) shown below.

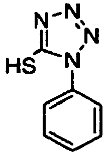

TCPA is Tetrachlorophthalic acid. It has structure (C-6) shown below.

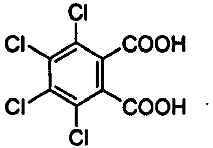

PHZ is Phthalazine (Structure 1-1).

PAZ is Phthalazone (Structure II-3).

C1-PHZ is 1,4-Dichlorophthalazine (Structure 1-3).

Bu-PHZ is 6-*iso*-Butylphthalazine (Structure 1-4).

PYZ is Pyridazine (Structure I-2).

### Preparation of Polymer premix solution:

A cellulose acetate butyrate polymer premix solution was prepared by mixing the following materials:

| Material | Amount (g) |
|---|---|
| CAB171-15 | 1.20 |
| Bismuth neodecanoate | 0.07 |
| THDI | 0.30 |
| MEK | 43.80 |
| Isopropanol | 69.32 |
| Ethyl lactate | 69.32 |

### Preparation of Transparent Silver Nanowire Coatings

To a solution of 1.46 g of polymer premix solution, prepared as shown above, was added 0.12 g of a silver nanowire dispersion in 2-propanol (∼5.0 % silver nanowires), and 0.015 g solution containing anti-corrosion compound as shown in TABLE I.

The resulting dispersion was mixed on a roller mixer for 10 minutes to obtain a uniform dispersion. The dispersion was coated onto a 4-mil (102 µm) clear polyethylene terephthalate support using a #10 Mayer rod. The resulting coating was dried in oven at 220°F (104°C) for 6 minutes to obtain a transparent and conductive film suitable for testing.

**TABLE I - Preparation of anti-corrosion solution**

| **Solution#** | **Chemical** | **Structure** | **Source** | **Amount (g)** | **MW** | **mmol** | **MEK (g)** |
|---|---|---|---|---|---|---|---|
| ACS-1 | BZT | C-2 | Aldrich | 0.020 | 119 | 0.168 | 10 |
| ACS-2 | PMT | C-5 | Aldrich | 0.030 | 178 | 0.169 | 10 |
| ACS-3 | MMBI | C-3 | Aldrich | 0.027 | 164 | 0.165 | 10 |
| ACS-4 | 4-MPA | C-4 | Aldrich | 0.030 | 180 | 0.167 | 10 |
| ACS-5 | TCPA | C-6 | Aldrich | 0.051 | 304 | 0.168 | 10 |
| ACS-6 | BHTT | C-1 | US 6,841,343 | 0.032 | 191 | 0.168 | 10 |
| | | | | | | | |
| ACS-7 | PHZ | I-1 | Aldrich | 0.022 | 130 | 0.169 | 10 |
| ACS-8 | PAZ | II-3 | Aldrich | 0.025 | 146 | 0.171 | 10 |
| ACS-9 | C1PHZ | I-3 | Aldrich | 0.033 | 199 | 0.166 | 10 |
| ACS-10 | BuPHZ | 1-4 | JP 11180961(A), (1999) | 0.031 | 186 | 0.167 | 10 |
| ACS-11 | PYZ | I-2 | Aldrich | 0.013 | 80 | 0.163 | 10 |

### Measurement of Surface Resistivity upon Exposure to Hydrogen Sulfide (H₂S):

Surface resistivity of the conductive sample coatings was measured using an R-CHEK model RC2175 Surface Resistivity meter available from Electronic Design To Market, Inc. (Toledo, OH).

Surface resistivity of the conductive sample coatings was measured immediately after coating to provide initial values.

The conductive sample coatings were then placed in a closed, air tight chamber having a volume of about 4 liters. A bottle containing a solution of thioacetamide (0.20 g thioacetamide in 100 g water) was placed in the chamber and opened. The test chamber was closed and the samples were exposed to H₂S in the chamber for several days. Thioacetamide is a convenient source for producing low concentration of hydrogen sulfide gas (Journal) of Chemical Education, 32, 474, 1955**)** and, if desired, the concentration of hydrogen sulfide in airtight chamber can be regulated by changing thioacetamide concentration in the solution. The resistivity of the samples was checked periodically to monitor the change in film resistivity due to reaction of the silver nanowire coatings with hydrogen sulfide gas generated by the decomposition of thioacetamide. This test provides accelerated corrosion of the samples.

The accelerated corrosion test results, shown below in TABLE II, demonstrate that conductivity of transparent conductive films containing no anti-corrosion compound deteriorated rapidly after several days of exposure to hydrogen sulfide in the thioacetamide solution chamber, comparative example Comp-1.

For several aromatic compounds tested, some of them containing either nitrogen or sulfur groups, poor initial film conductivity was observed when adding these compounds to the conductive film formulations, Comp-2, Comp-3, and Comp-4. These compounds are not suitable as anti-corrosion agents for transparent conductive film.

For some other compounds when added into conductive film formulation, the initial conductivities of resultant films were not significantly altered. However, these compounds do not provide any anti-corrosion effects as the conductivity of these samples changed significantly from the initial value after going through the H₂S accelerated test, Comp-5, Comp-6, and Comp-7.

For conductive film samples containing an inventive 1,2-diazine compound, Inv-1 to Inv-5, the conductivity of samples were not affected significantly after 8 days of testing in an H₂S environment. These results demonstrate the significant stability improvement provided by the addition of 1,2-diazine compounds to transparent conductive film construction comprising silver nanowires.

The invention has been described in detail with particular reference to certain preferred embodiments thereof, but it will be understood that variations and modifications can be effected within the spirit and scope of the invention.

**TABLE II - Conductivity changes after exposure to H₂S using the accelerated aging test method.**

| **Sample#** | **Anti-Corrosion Agent - Structure** | | | **Film Resistivity (ohm/sq)** | | | | **%Change in Resistivity After 8 days** |
|---|---|---|---|---|---|---|---|---|
| | | | **Initial** | **Day 2** | **Day 4** | **Day 6** | **Day 8** | |
| Comp-1 | None | | 104 | 116 | 132 | 132 | 142 | +36.5% |
| Comp-2 | MMBI | C-3 | non-cond. | - | - | - | - | N/A |
| Comp-3 | 4-MPA ' | C-4 | non-cond. | - | - | - | - | N/A |
| Comp-4 | TCPA | C-6 | 1370 | non-cond. | - | - | - | >100% |
| Comp-5 | PMT | C-5 | 320 | 258 | 290 | 265 | 236 | -26.3% |
| Comp-6 | BZT | C-2 | 199 | 263 | 288 | 311 | 323 | +62.3% |
| Comp-7 | BHTT | C-1 | 237 | 243 | 252 | 323 | 381 | +60.8% |
| | | | | | | | | |
| Inv-1 | PHZ | I-1 | 114 | 120 | 115 | 117 | 117 | +2.6% |
| Inv-2 | PAZ | II-3 | 149 | 145 | 149 | 148 | 159 | +6.7% |
| Inv-3 | C1PHZ | I-3 | 114 | 114 | 110 | 109 | 108 | -5.3% |
| Inv-4 | BuPHZ | I-4 | 131 | 127 | 129 | 135 | 138 | +5.3% |
| Inv-5 | PYZ | I-2 | 237 | 274 | 257 | 246 | 250 | +5.5% |

## Claims

1. A transparent conductive article comprising:
a transparent support having coated thereon;
a transparent conductive film comprising a random network of silver nanowires dispersed within a polymer binder; and
one or more 1,2-diazine compounds having the general structure (I) or (II); 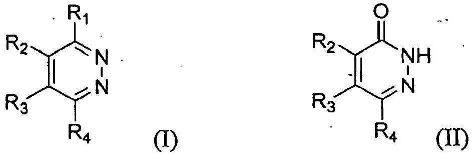 wherein R₁, R₂, R₃, and R₄ are independently: hydrogen, a substituted or unsubstituted alkyl group comprising up to 20 carbon atoms, a substituted or unsubstituted aryl group comprising up to 10 carbon atoms, a substituted or unsubstituted heteroaryl group comprising up to 10 carbon, oxygen, nitrogen, or sulfur atoms, a halogen atom (F, Cl, Br, or I), a hydroxyl group (OH), a thiol group (SH), a substituted or unsubstituted alkoxy group comprising up to 20 carbon atoms, an amino group (NR₅R₆) where R₅ and R₆ are independently a hydrogen, an alkyl group comprising up to 20 carbon atoms, or an aryl group comprising up to 10 carbon atoms, a thioether group (SR₇) where R₇ is an alkyl group comprising up to 20 carbon atoms, or an aryl group comprising up to 10 carbon atoms, a sulfoxy group (SOR₇), a sulfone group (SO₂R₇), a carboxylic acid group (COOH) or a salt of a carboxylic acid (CO₂⁻ M⁺) where M⁺ is a cation (such as a metal cation, a quaternary ammonium cation or a quaternary phosphonium cation), a carboxamide group (CONR₅R₆), an acylamino group (NR₅COR₇), an acyl group (COR₇), an acyloxy group (OCOR₇), or a sulfonamido group (SO₂NR₅R₆),
or (R₁ and R₂) or (R₂ and R₃) or (R₃ and R₄) are joined together with 1 to 5 carbon, nitrogen, sulfur, and/or oxygen atoms to form an alicylic or aromatic ring(s).

2. The transparent conductive article of claim 1, wherein
R₁, R₂, R₃, and R₄ are hydrogen, halogen, hydroxyl, alkyl groups comprising 1 to 6 carbon atoms, aryl groups comprising 6 carbon atoms, alkoxy groups comprising 1 to 6 carbon atoms,
or (R₁ and R₂) or (R₂ and R₃) or (R₃ and R₄) are joined together with 4 carbon atoms to form a fused benzo ring.

3. The transparent conductive article of claim 1, wherein the 1,2-diazine compounds are represented by one or more of the structures:

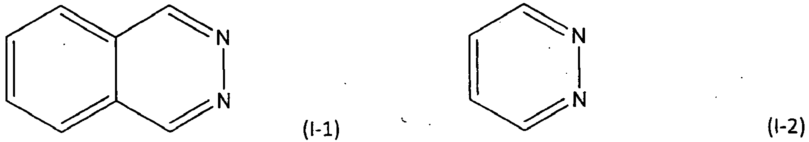

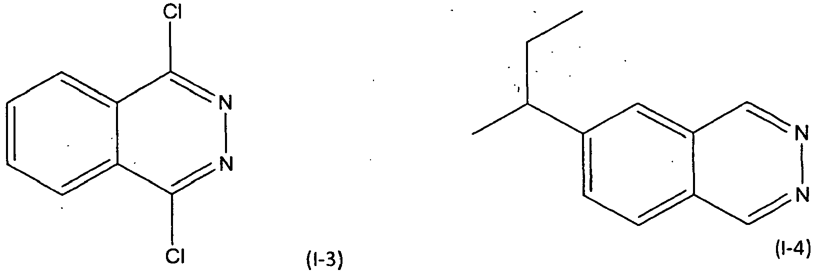

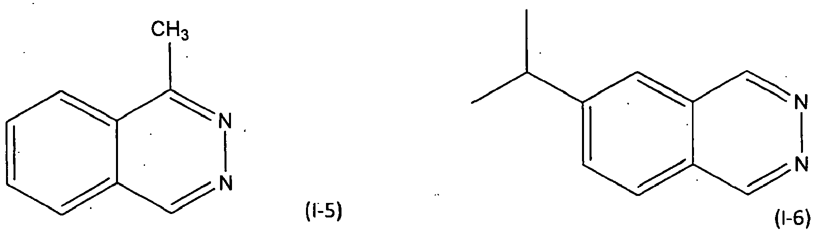

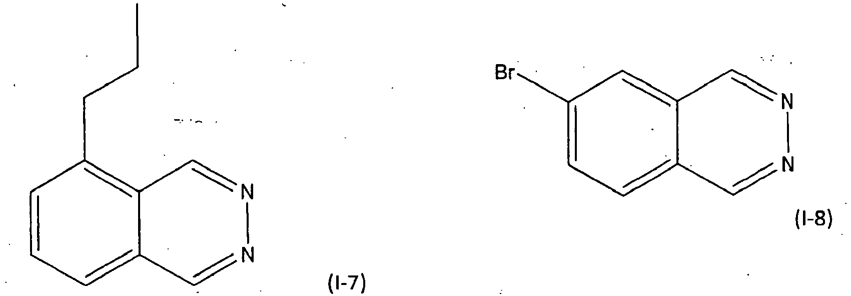

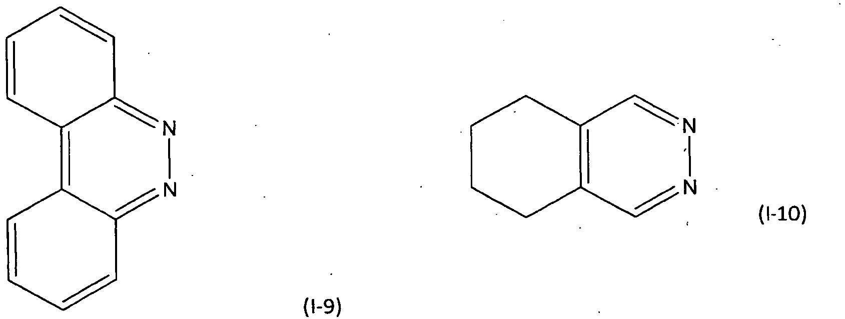

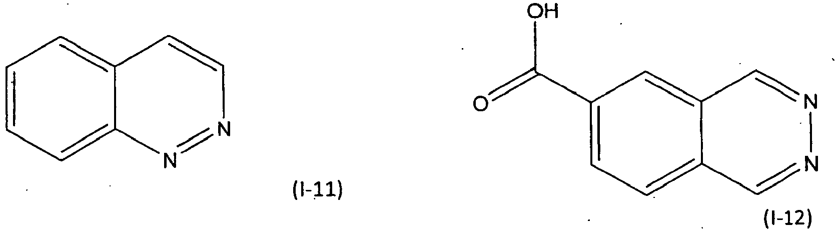

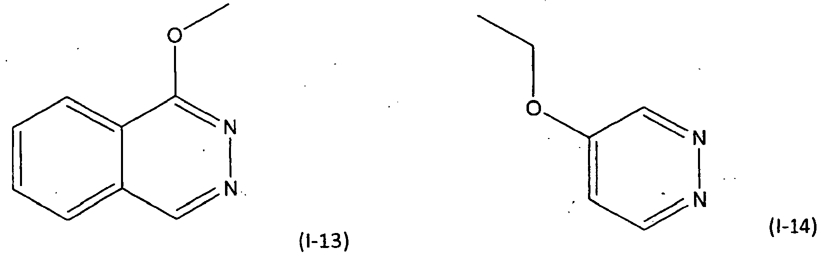

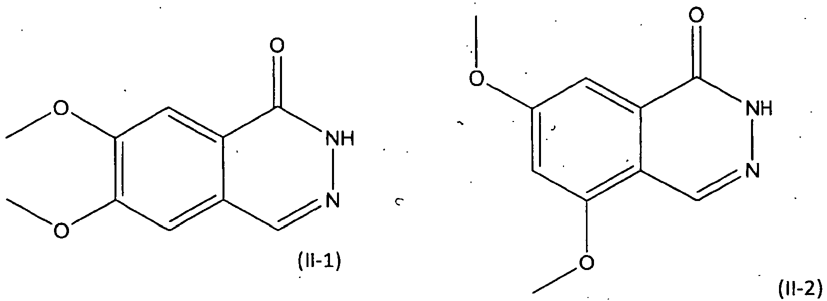

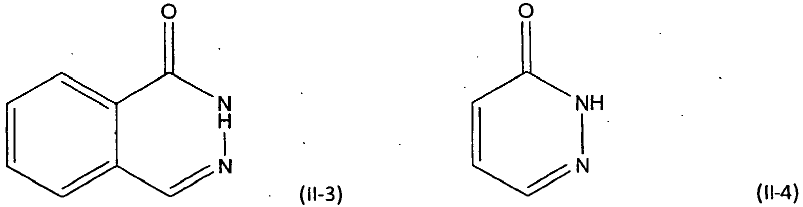

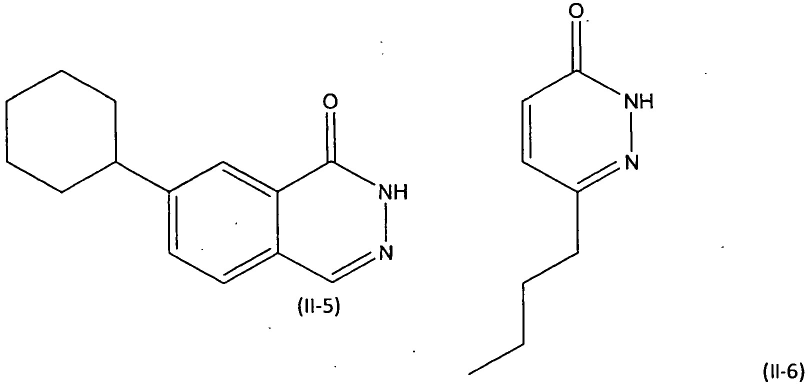

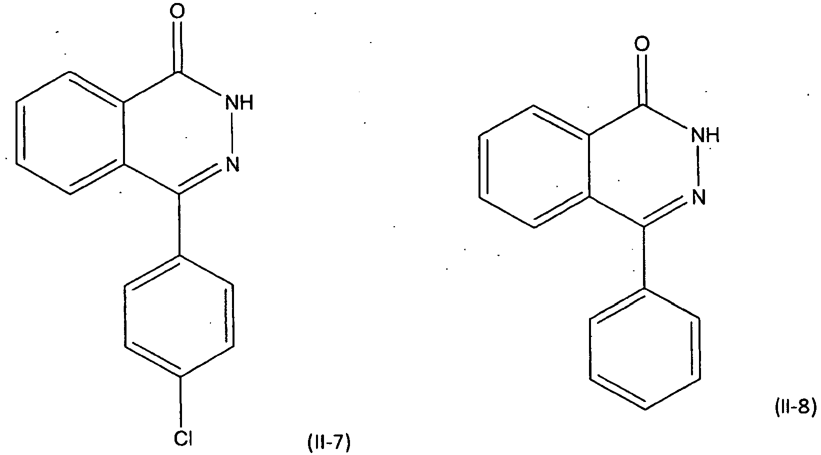

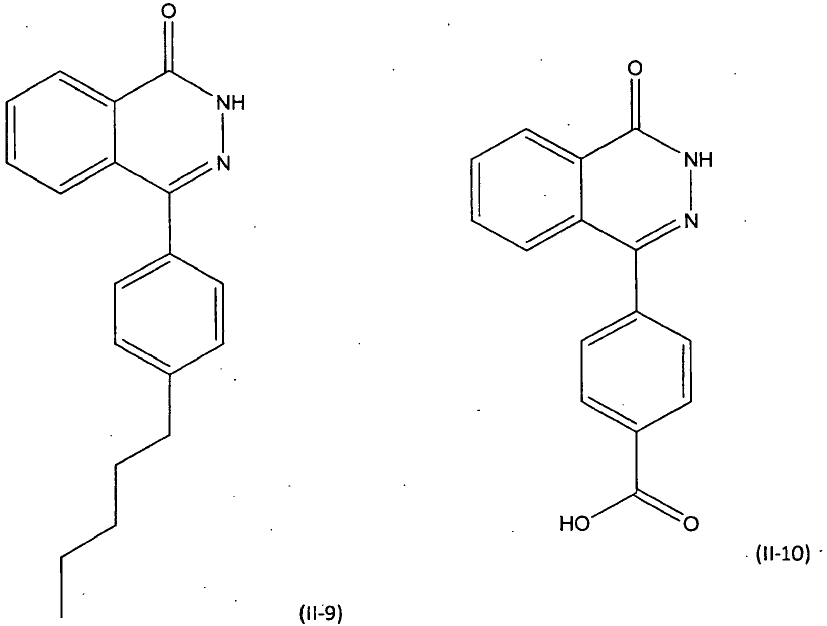

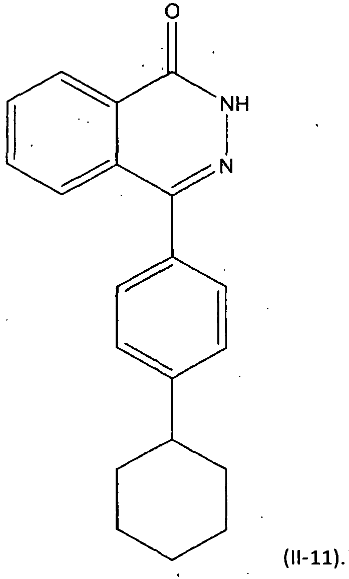

4. The transparent conductive article of claim 1, wherein the 1,2-diazine compounds are represented by one or more of the structures: 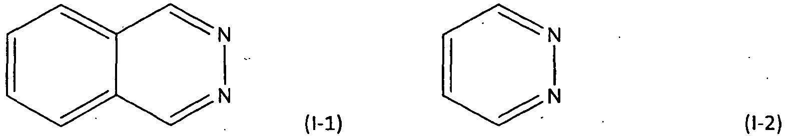 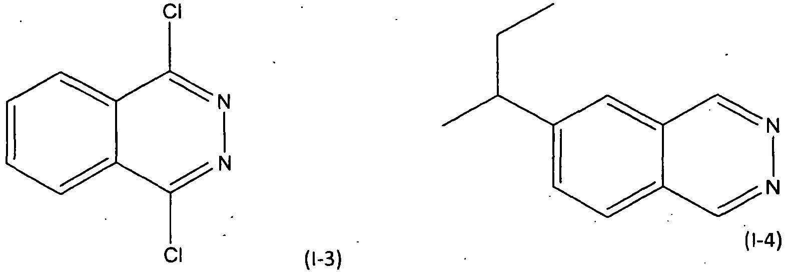 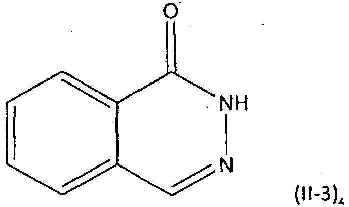 wherein the transparent support is a transparent polyethylene terephthalate support, the silver nanowires have an aspect ratio from 20 to 3300, and the silver nanowires are present in an amount sufficient to provide a surface resistivity of 500 ohms/sq or less and a transmittance of at least 70% across the entire spectrum range of from 350 nm to 1100 nm.

5. The transparent conductive article of claim 1, wherein the silver nanowires are present in an amount of from 20 mg/m² to 500 mg/m².

6. The transparent conductive article of claim 1, wherein the silver nanowires have an aspect ratio of from 20 to 3300.

7. The transparent conductive article of claim 1, wherein the polymer binder comprises gelatin, polyvinyl alcohol, or mixtures thereof.

8. The transparent conductive article of claim 7, wherein the polymer binder further comprises up to 50 wt% of one or more additional water soluble polymers.

9. The transparent conductive article of claim 8, wherein one or more of the additional water soluble polymers is a polyacrylic polymer.

10. The transparent conductive article of claim 1, wherein the polymer binder comprises an organic solvent soluble polymer.

11. The transparent conductive article of claim 10, wherein the organic solvent soluble polymer binder comprises a cellulose ester polymer.

12. The transparent conductive article of claim 10, wherein the organic solvent soluble polymer binder comprises cellulose acetate, cellulose acetate butyrate, or cellulose acetate propionate, or mixtures thereof.

13. The transparent conductive article of claim 10, further comprising up to 50 wt% of one or more additional organic solvent soluble polymers.

14. The transparent conductive article of claim 13, wherein the one or more of the additional organic solvent soluble polymers is a polyester polymer.

15. A process for the formation of a transparent conductive article comprising:
preparing a dispersion of silver nanowires in a solution of 1,2-diazine compound and polymer binder;
wherein the 1,2-diazine compound has the general structure (I) or (II); 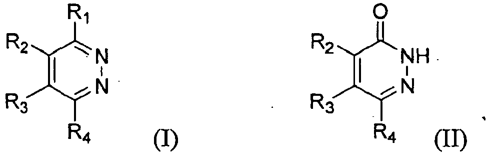 wherein R₁, R₂, R₃, and R₄ are be independently: hydrogen, a substituted or unsubstituted alkyl group comprising up to 20 carbon atoms, a substituted or unsubstituted aryl group comprising up to 10 carbon atoms, a substituted or unsubstituted heteroaryl group comprising up to 10 carbon, oxygen, nitrogen, or sulfur atoms, a halogen atom (F, Cl, Br, or I), a hydroxyl group (OH), a thiol group (SH), a substituted or unsubstituted alkoxy group comprising up to 20 carbon atoms, an amino group (NR₅R₆) where R₅ and R₆ are independently a hydrogen, an alkyl group comprising up to 20 carbon atoms, or an aryl group comprising up to 10 carbon atoms, a thioether group (SR₇) where R₇ is an alkyl group comprising up to 20 carbon atoms, or an aryl group comprising up to 10 carbon atoms, a sulfoxy group (SOR₇), a sulfone group (SO₂R₇), a carboxylic acid group (COOH) or a salt of a carboxylic acid (CO₂⁻ M⁺) where M⁺ is a cation (such as a metal cation, a quaternary ammonium cation or a quaternary phosphonium cation), a carboxamide group (CONR₅R₆), an acylamino group (NR₅COR₇), an acyl group (COR₇), an acyloxy group (OCOR₇), or a sulfonamido group (SO₂NR₅R₆);
or (R₁ and R₂) or (R₂ and R₃) or (R₃ and R₄) are joined together with 1 to 5 carbon, nitrogen, sulfur, and/or oxygen atoms to form an alicylic or aromatic ring(s);
coating, the dispersion of silver nanowires in the solution of 1,2-diazine compound and polymer binder onto a transparent support; and
drying the coating on the support to form a random network of silver nanowires.

## Patentansprüche

1. Transparenter leitfähiger Gegenstand, welcher Folgendes aufweist:
einen transparenten Träger, der beschichtet ist;
einen transparenten leitfähigen Film, der ein zufälliges Netzwerk von Silber-Nanodrähte aufweist, die in einem Polymer-Bindemittel verteilt sind; und
ein oder mehrere 1,2-Diazin-Verbindungen mit der allgemeinen Struktur (I) oder (II); 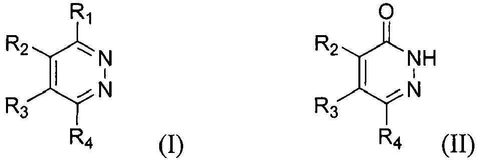 wobei R₁, R₂, R₃, und R₄ unabhängig voneinander Folgendes sind: Wasserstoff, eine substituierte oder unsubstituierte Alkylgruppe mit bis zu 20 Kohlenstoffatomen, eine substituierte oder unsubstituierte Arylgruppe mit bis zu 10 Kohlenstoffatomen, eine substituierte oder unsubstituierte Heteroarylgruppe mit bis zu 10 Kohlenstoff-, Sauerstoff-, Stickstoff- oder Schwefelatomen, ein Halogenatom (F, Cl, Br oder I), eine Hydroxylgruppe (OH), eine Thiolgruppe (SH), eine substituierte oder unsubstituierte Alkoxygruppe mit bis zu 20 Kohlenstoffatomen, eine Aminogruppe (NR₅R₆), wobei R₅ und R₆ unabhängig voneinander Folgendes sind: ein Wasserstoff, eine Alkylgruppe mit bis zu 20 Kohlenstoffatomen oder eine Arylgruppe mit bis zu 10 Kohlenstoffatomen, eine Thioethergruppe (SR₇), wobei R₇ eine Alkylgruppe mit bis zu 20 Kohlenstoffatomen ist oder eine Arylgruppe mit bis zu 10 Kohlenstoffatomen, eine Sulfoxygruppe (SOR₇), eine Sulfongruppe (SO₂R₇), eine Carbonsäuregruppe (COOH) oder ein Salz einer Carbonsäure (CO₂⁻M⁺), wobei M⁺ ein Kation (beispielsweise ein Metallkation, ein quartäres Ammoniumkation oder ein quartäres Phosphonium-Kation) ist, eine Carbonsäureamidgruppe (CONR₅R₆), eine Acylaminogruppe (NR₅COR₇), eine Acylgruppe (COR₇), eine Acyloxygruppe (OCOR₇) oder eine Sulfonamidgruppe (SO₂NR₅R₆),
oder wobei (R₁ und R₂) oder (R₂ und R₃) oder (R₃ und R₄) mit 1 bis 5 Kohlenstoff-, Stickstoff-, Schwefel- und/oder Sauerstoffatomen aneinander gefügt sind, um einen alicyclischen oder aromatischen Ring bzw. alicyclische oder aromatische Ringe zu bilden.

2. Transparenter leitender Gegenstand nach Anspruch 1, wobei R₁, R₂, R₃, und R₄ Wasserstoff-, Halogen-, Hydroxyl-, Alkylgruppen mit 1 bis 6 Kohlenstoffatomen, Arylgruppen mit 6 Kohlenstoffatomen, Alkoxygruppen mit 1 bis 6 Kohlenstoffatomen sind,
oder wobei (R₁ und R₂) oder (R₂ und R₃) oder (R₃ und R₄) mit 4 Kohlenstoffatomen aneinander gefügt sind, um einen festen Benzo-Ring zu bilden.

3. Transparenter leitender Gegenstand nach Anspruch 1 oder 2, wobei die 1,2-Diazin-Verbindungen durch eine oder mehrere der folgenden Strukturen dargestellt werden:

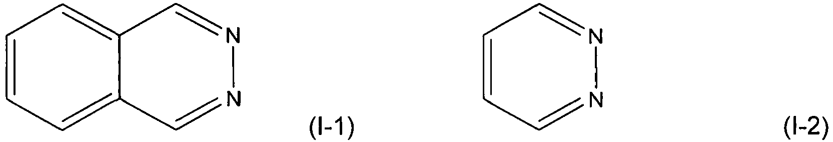

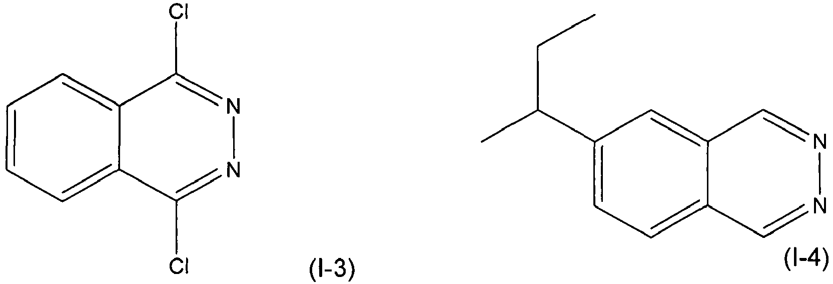

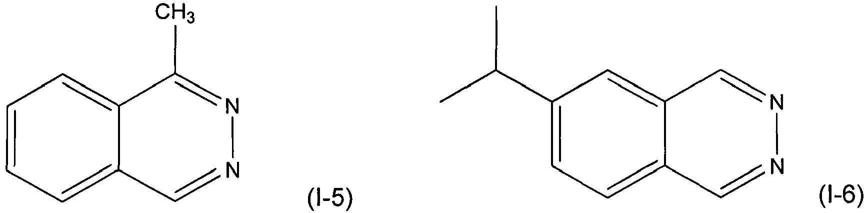

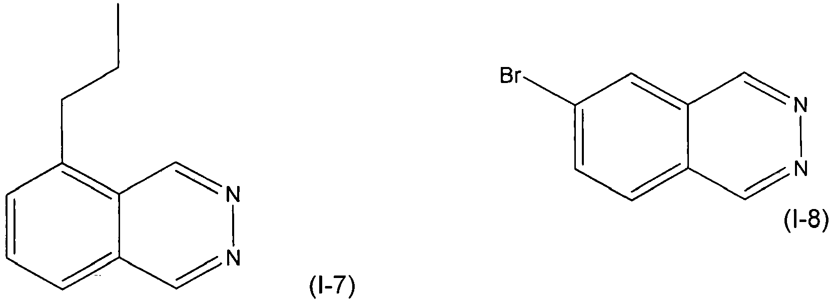

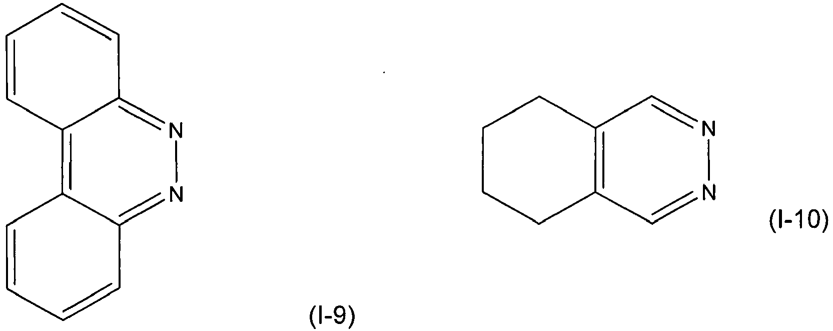

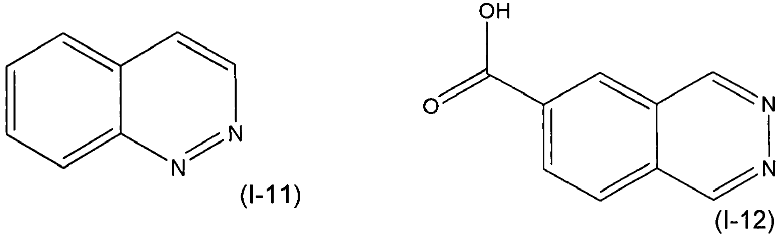

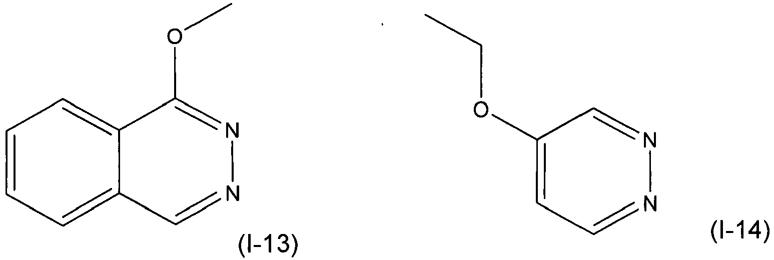

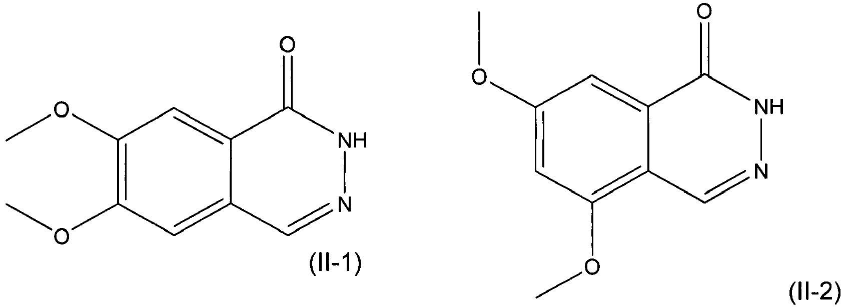

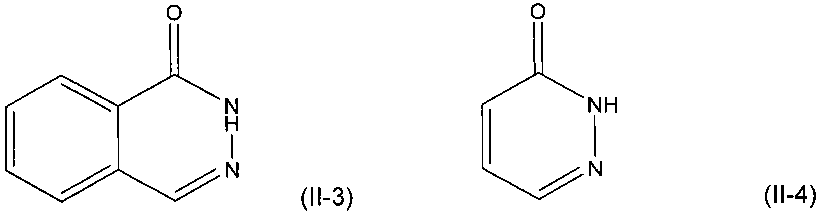

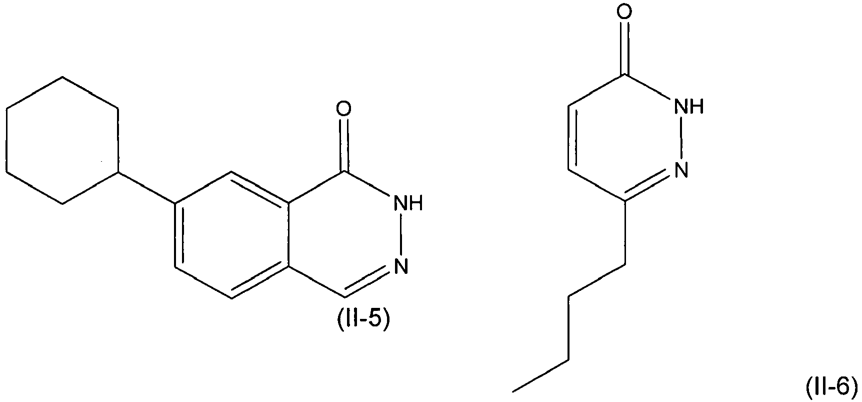

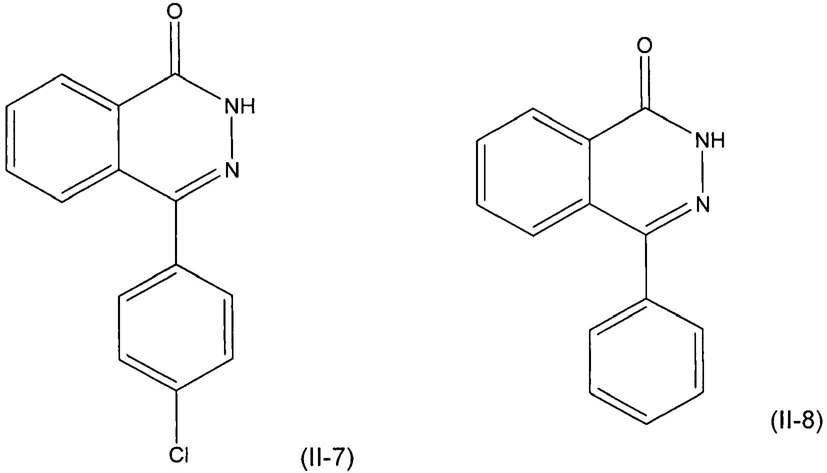

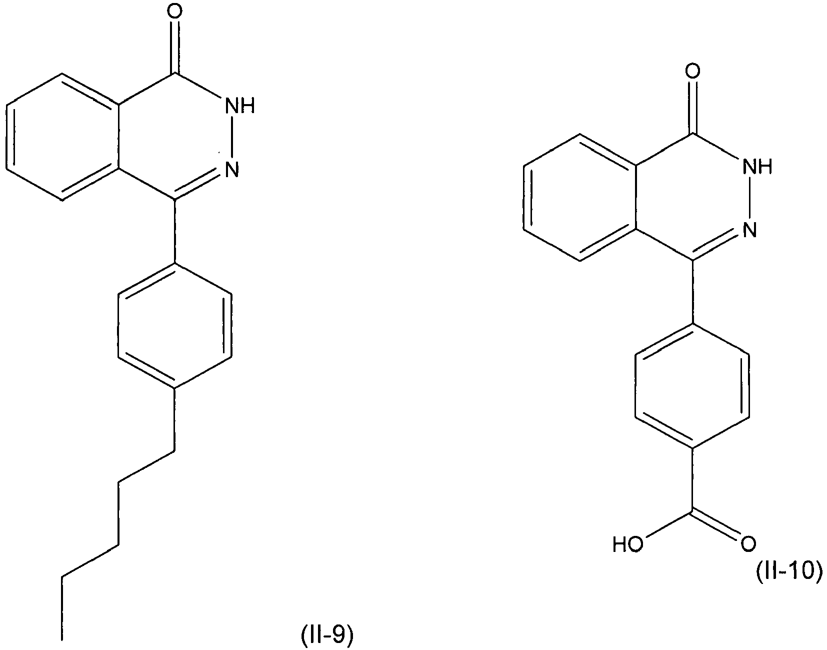

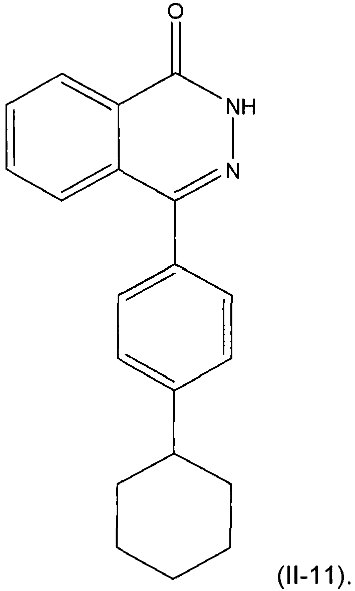

4. Transparenter leitender Gegenstand nach Anspruch 1, wobei die 1,2-Diazin-Verbindungen durch eine oder mehrere der folgenden Strukturen dargestellt werden: 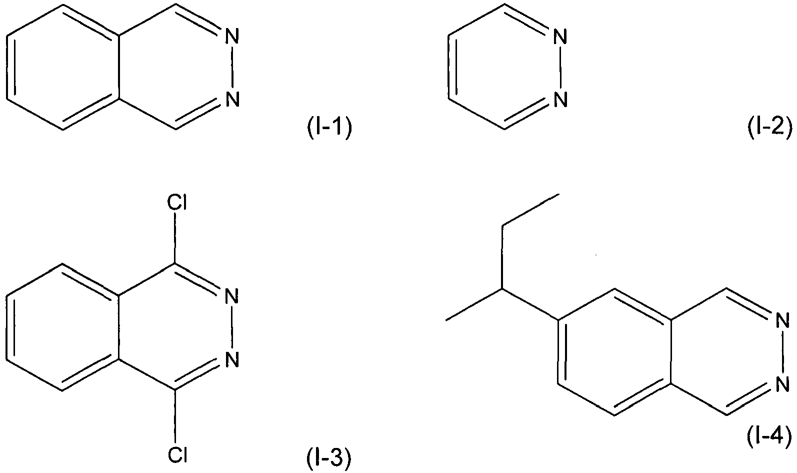 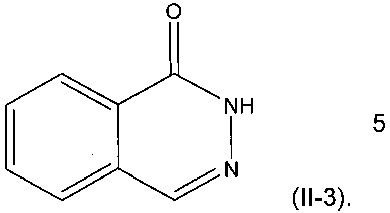 wobei der transparente Träger ein transparenter Polyethylenterephthalat-Träger ist, die Silber-Nanodrähte ein Seitenverhältnis von 20 bis 3300 haben, und die Silber-Nanodrähte in einer Menge vorhanden sind, die ausreicht, um einen Oberflächenwiderstand von 500 Ohm/Flächenquadrat (sq) oder weniger vorzusehen und einen Durchlässigkeitsgrad von mindestens 70% über die gesamte Bandbreite bzw. den gesamten Spektrumsbereich von 350 nm bis 1100 nm.

5. Transparenter leitfähiger Gegenstand nach Anspruch 1, wobei die Silber-Nanodrähte in einer Menge von 20 mg/m² bis 500 mg/m² vorhanden sind.

6. Transparenter leitfähiger Gegenstand nach Anspruch 1, wobei die Silber-Nanodrähte ein Seitenverhältnis von 20 bis 3300 haben.

7. Transparenter leitfähiger Gegenstand nach Anspruch 1, wobei das Polymer-Bindemittel Gelatine, Polyvinylalkohol, oder Mischungen davon aufweist.

8. Transparenter leitfähiger Gegenstand nach Anspruch 7, wobei das Polymer-Bindemittel ferner bis zu 50 Gewichts-% von einem oder mehreren zusätzlichen wasserlöslichen Polymeren aufweist.

9. Transparenter leitfähiger Gegenstand nach Anspruch 8, wobei ein oder mehrere der zusätzlichen wasserlöslichen Polymere ein Polyacrylpolymer ist.

10. Transparenter leitfähiger Gegenstand nach Anspruch 1, wobei das Polymer-Bindemittel ein in organischem Lösungsmittel lösliches Polymer aufweist.

11. Transparenter leitfähiger Gegenstand nach Anspruch 10, wobei das in organischem Lösungsmittel lösliche Polymer-Bindemittel ein Celluloseester-Polymer aufweist.

12. Transparenter leitfähiger Gegenstand nach Anspruch 10, wobei das in organischem Lösungsmittel lösliche Polymer-Bindemittel Celluloseacetat, Celluloseacetatbutyrat oder Celluloseacetatpropionat oder Mischungen davon aufweist.

13. Transparenter leitfähiger Gegenstand nach Anspruch 10, der weiterhin bis zu 50 Gewichts-% von einem oder mehreren zusätzlichen in organischem Lösungsmittel löslichen Polymeren aufweist.

14. Transparenter leitfähiger Gegenstand nach Anspruch 13, wobei das eine oder die mehreren in organischem Lösungsmittel löslichen Polymere ein Polyesterpolymer ist.

15. Verfahren zur Bildung eines transparenten leitfähigen Gegenstandes, das Folgendes aufweist:
Herstellen einer Dispersion von Silber-Nanodrähten in einer Lösung einer 1,2-Diazinverbindung und einem Polymer-Bindemittel;
wobei die 1,2-Diazinverbindung die allgemeinen Struktur (I) oder (II) hat: 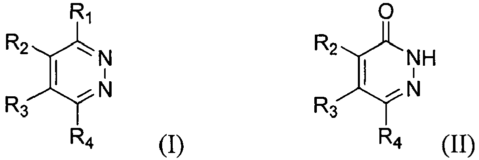 wobei R₁, R₂, R₃, und R₄ unabhängig voneinander Folgendes sind: Wasserstoff, eine substituierte oder unsubstituierte Alkylgruppe mit bis zu 20 Kohlenstoffatomen, eine substituierte oder unsubstituierte Arylgruppe mit bis zu 10 Kohlenstoffatomen, eine substituierte oder unsubstituierte Heteroarylgruppe mit bis zu 10 Kohlenstoff-, Sauerstoff-, Stickstoff- oder Schwefelatomen, ein Halogenatom (F, Cl, Br oder I), eine Hydroxylgruppe (OH), eine Thiolgruppe (SH), eine substituierte oder unsubstituierte Alkoxygruppe mit bis zu 20 Kohlenstoffatomen , eine Aminogruppe (NR₅R₆), wobei R₅ und R₆ unabhängig voneinander Folgendes aufweisen: Wasserstoff, eine Alkylgruppe mit bis zu 20 Kohlenstoffatomen oder eine Arylgruppe mit bis zu 10 Kohlenstoffatomen, eine Thioethergruppe (SR₇), wobei R₇ eine Alkylgruppe mit bis zu 20 Kohlenstoffatomen ist oder eine Arylgruppe mit bis zu 10 Kohlenstoffatomen, eine Sulfoxygruppe (SOR₇), eine Sulfongruppe (SO₂R₇), eine Carbonsäuregruppe (COOH) oder ein Salz einer Carbonsäure (CO₂⁻M⁺), wobei M⁺ ein Kation (beispielsweise ein Metallkation, ein quartäres Ammoniumkation oder ein quartäres Phosphonium-Kation) ist, eine Carboxamidgruppe (CONR₅R₆), eine Acylaminogruppe (NR₅COR₇), eine Acylgruppe (COR₇), eine Acyloxygruppe Gruppe (OCOR₇) oder eine Sulfonamidogruppe (SO₂NR₅R₆),
oder wobei (R₁ und R₂) oder (R₂ und R₃) oder (R₃ und R₄) mit 1 bis 5 Kohlenstoff-, Stickstoff-, Schwefel- und / oder Sauerstoffatomen aneinander gefügt sind, um einen alicyclischen oder aromatischen Ring bzw. alicyclische oder aromatische Ringe zu bilden;
Beschichten der Dispersion von Silber-Nanodrähte in der Lösung der 1,2-Diazinverbindung und Polymer-Bindemittel auf einen transparenten Träger; und
Trocknen der Beschichtung auf dem Träger, um ein zufälliges Netzwerk von Silber-Nanodrähten zu bilden.

## Revendications

1. Objet conducteur transparent comprenant :
un support transparent sur lequel est appliqué ;
un film conducteur transparent comprenant un réseau aléatoire de nanofils d'argent dispersés dans un liant polymère ; et
un ou plusieurs composés 1,2-diazine ayant la structure générale (I) ou (II) ; 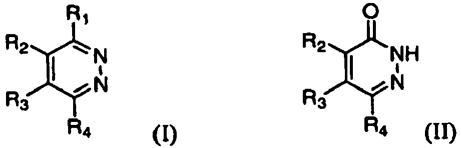 où R₁, R₂, R₃ et R₄ sont indépendamment : un hydrogène, un groupe alkyle substitué ou non substitué comprenant jusqu'à 20 atomes de carbone, un groupe aryle substitué ou non substitué comprenant jusqu'à 10 atomes de carbone, un groupe hétéro-aryle substitué ou non substitué comprenant jusqu'à 10 atomes de carbone, des atomes d'oxygène, d'azote, ou de soufre, un atome d'halogène (F, Cl, Br ou I), un groupe hydroxyle (OH), un groupe thiol (SH), un groupe alcoxyle substitué ou non substitué comprenant jusqu'à 20 atomes de carbone, un groupe amine (NR₅R₆) où R₅ et R₆ sont indépendamment un hydrogène, un groupe alkyle comprenant jusqu'à 20 atomes de carbone, ou un groupe aryle comprenant jusqu'à 10 atomes de carbone, un groupe thioéther (SR₇) où R₇ est un groupe alkyle comprenant jusqu'à 20 atomes de carbone, ou un groupe aryle comprenant jusqu'à 10 atomes de carbone, un groupe sulfoxyde (SOR₇), un groupe sulfonique (SO₂R₇), un groupe acide carboxylique (COOH) ou un sel d'un acide carboxylique (CO₂⁻M⁺) où M⁺ est un cation (comme un cation métallique, un cation ammonium quaternaire ou un cation phosphonium quaternaire), un groupe carboxamide (CONR₅R₆), un groupe acylamino (NR₅COR₇), un groupe acyle (COR₇), un groupe acyloxy (OCOR₇), ou un groupe sulfonamido (SO₂NR₅R₆),
où (R₁ et R₂) ou (R₂ et R₃) ou (R₃ et R₄) sont joints entre eux avec 1 à 5 atomes de carbone, d'azote, de soufre et/ou d'oxygène pour former un ou des noyaux alicyliques ou aromatiques.

2. Objet conducteur transparent selon la revendication 1, dans lequel :
R₁, R₂, R₃ et R₄ sont un hydrogène, des groupes halogène, hydroxyle, alkyle comprenant 1 à 6 atomes de carbone, des groupes aryle comprenant 6 atomes de carbone, des groupes alcoxyle comprenant 1 à 6 atomes de carbone,
ou (R₁ et R₂) ou (R₂ et R₃) ou (R₃ et R₄) sont joints entre eux avec 4 atomes de carbone pour former un noyau benzo fusionné.

3. Objet conducteur transparent selon la revendication 1, dans lequel les composés 1,2-diazine sont représentés par une ou plusieurs des structures suivantes :

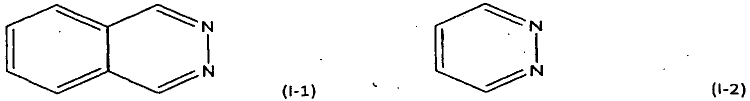

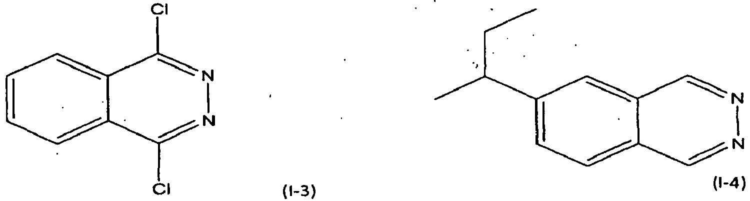

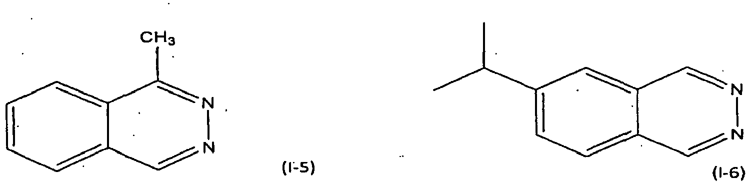

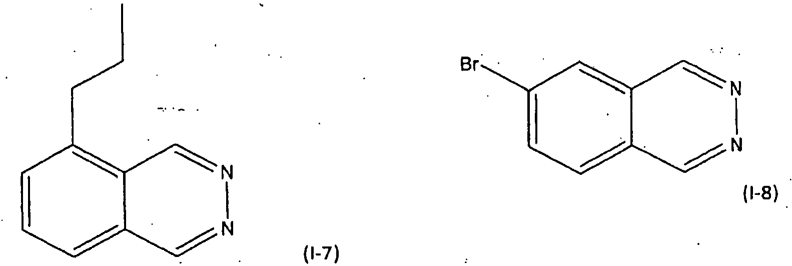

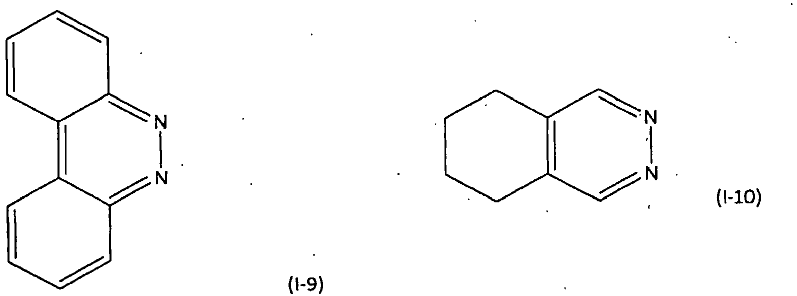

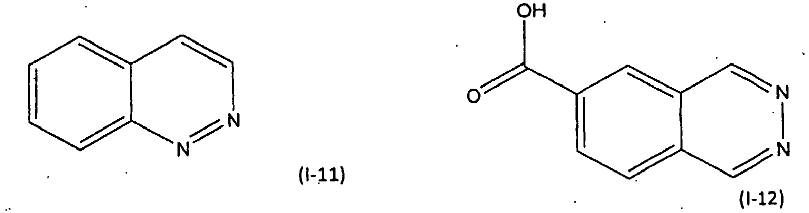

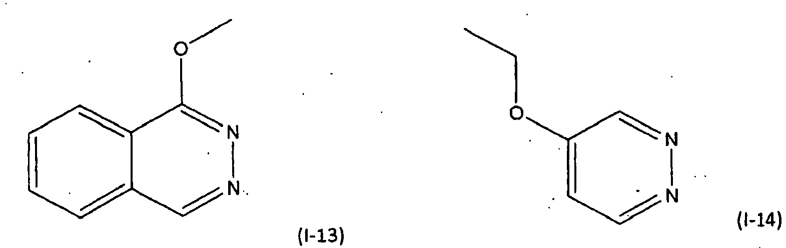

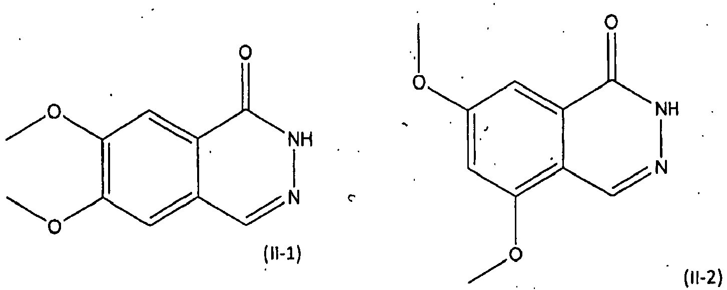

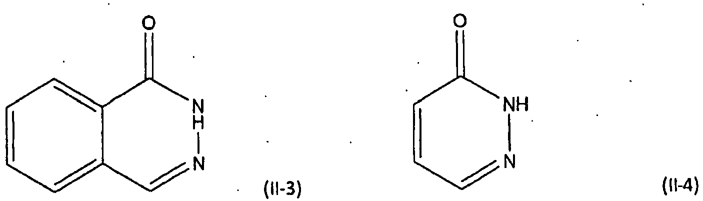

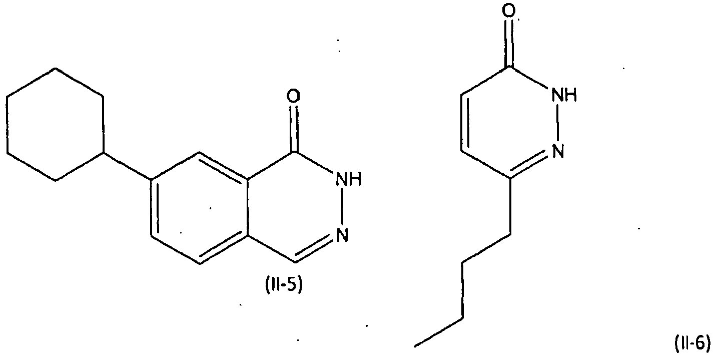

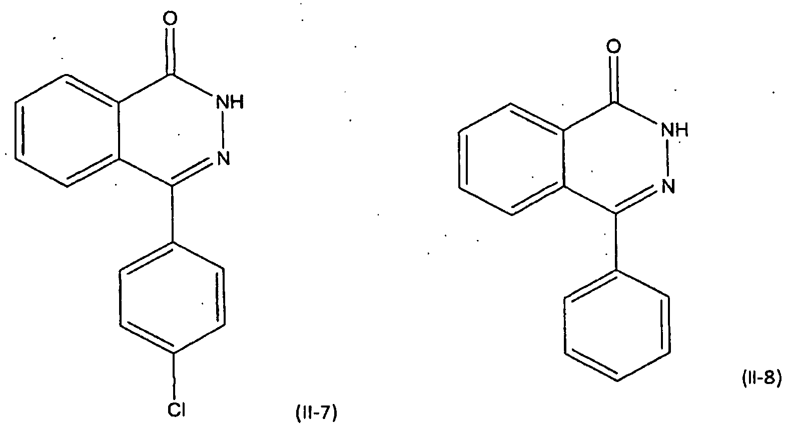

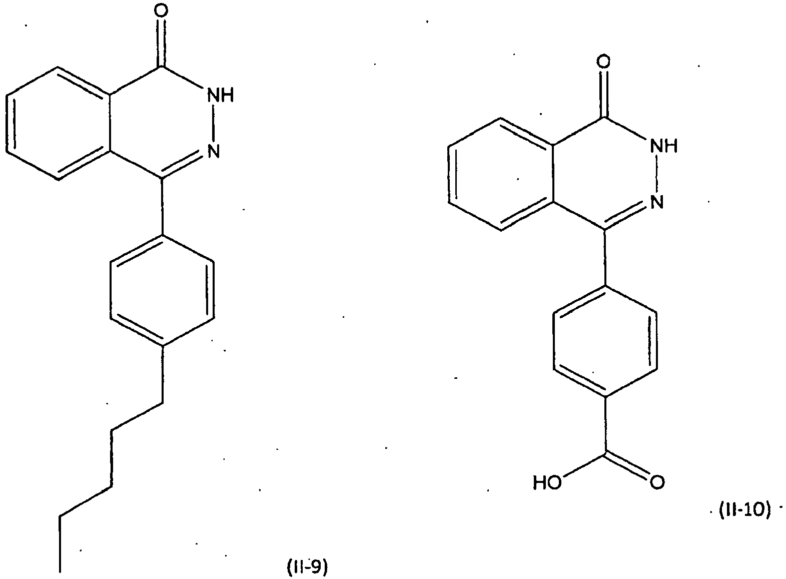

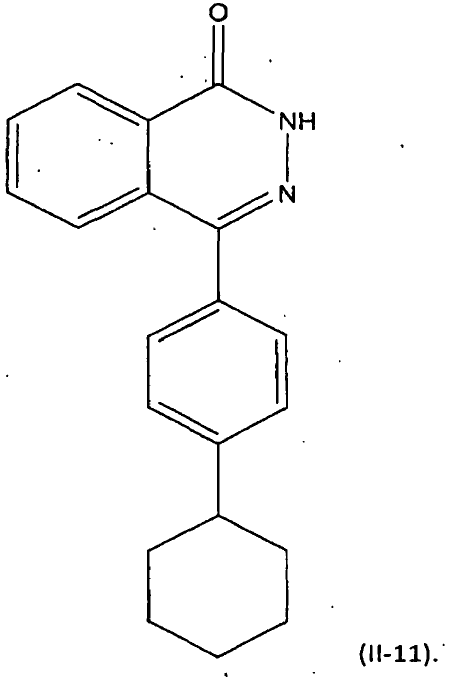

4. Objet conducteur transparent selon la revendication 1, dans lequel les composés 1,2-diazine sont représentés par une ou plusieurs des structures suivantes : 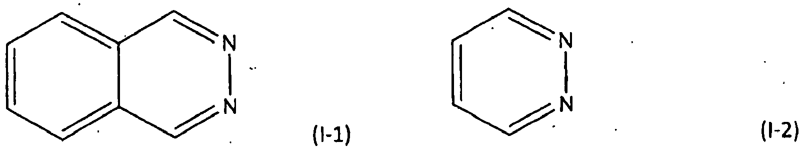 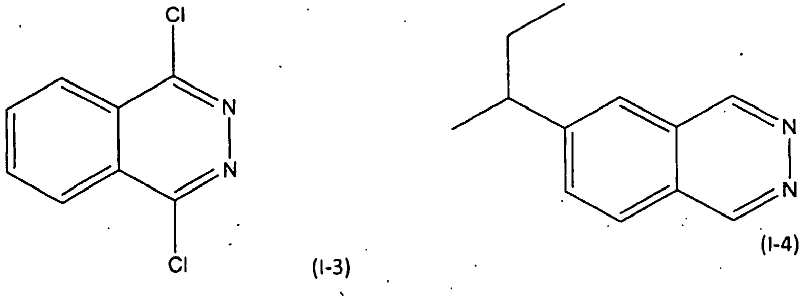 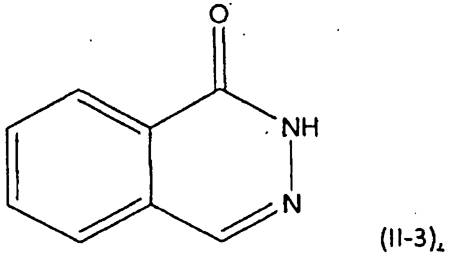 où le support transparent est un support transparent en polyéthylène téréphtalate, les nanofils d'argent ont un facteur de forme compris entre 20 et 3300, et les nanofils d'argent sont présents dans une quantité suffisante pour donner une résistivité de surface de 500 ohms/carré ou moins ou une transmittance d'au moins 70 % sur toute la plage spectrale comprise entre 350 nm et 1100 nm.

5. Objet conducteur transparent selon la revendication 1, dans lequel les nanofils d'argent sont présents dans une quantité comprise entre 20 mg/m² et 500 mg/m².

6. Objet conducteur transparent selon la revendication 1, dans lequel les nanofils d'argent ont un facteur de forme compris entre 20 et 3300.

7. Objet conducteur transparent selon la revendication 1, dans lequel le liant polymère comprend de la gélatine, de l'alcool polyvinylique, ou leurs mélanges.

8. Objet conducteur transparent selon la revendication 7, dans lequel le liant polymère comprend en outre jusqu'à 50 % en poids d'un ou plusieurs polymères additionnels solubles dans l'eau.

9. Objet conducteur transparent selon la revendication 8, dans lequel un ou plusieurs des polymères additionnels solubles dans l'eau sont un polymère polyacrylique.

10. Objet conducteur transparent selon la revendication 1, dans lequel le liant polymère comprend un polymère soluble dans un solvant organique.

11. Objet conducteur transparent selon la revendication 10, dans lequel le liant polymère soluble dans un solvant organique comprend un polymère ester de cellulose.

12. Objet conducteur transparent selon la revendication 10, dans lequel le liant polymère soluble dans un solvant organique comprend de l'acétate de cellulose, de l'acétobutyrate de cellulose, ou de l'acétopropionate de cellulose, ou leurs mélanges.

13. Objet conducteur transparent selon la revendication 10, comprenant en outre jusqu'à 50 % en poids d'un ou plusieurs polymères additionnels solubles dans un solvant organique.

14. Objet conducteur transparent selon la revendication 13, dans lequel lesdits un ou plusieurs polymères additionnels solubles dans un solvant organique sont un polymère de polyester.

15. Procédé de formation d'un objet conducteur transparent comprenant :
préparer une dispersion de nanofils d'argent dans une solution de composé 1,2-diazine et d'un liant polymère ;
dans lequel le composé 1,2-diazine a la structure générale (I) ou (II) ; 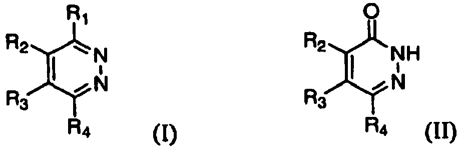
où R₁, R₂, R₃ et R₄ sont indépendamment : un hydrogène, un groupe alkyle substitué ou non substitué comprenant jusqu'à 20 atomes de carbone, un groupe aryle substitué ou non substitué comprenant jusqu'à 10 atomes de carbone, un groupe hétéro-aryle substitué ou non substitué comprenant jusqu'à 10 atomes de carbone, des atomes d'oxygène, d'azote, ou de soufre, un atome d'halogène (F, Cl, Br ou I), un groupe hydroxyle (OH), un groupe thiol (SH), un groupe alcoxyle substitué ou non substitué comprenant jusqu'à 20 atomes de carbone, un groupe amine (NR₅R₆) où R₅ et R₆ sont indépendamment un hydrogène, un groupe alkyle comprenant jusqu'à 20 atomes de carbone, ou un groupe aryle comprenant jusqu'à 10 atomes de carbone, un groupe thioéther (SR₇) où R₇ est un groupe alkyle comprenant jusqu'à 20 atomes de carbone, ou un groupe aryle comprenant jusqu'à 10 atomes de carbone, un groupe sulfoxyde (SOR₇), un groupe sulfonique (SO₂R₇), un groupe acide carboxylique (COOH) ou un sel d'un acide carboxylique (CO₂⁻M⁺) où M⁺ est un cation (comme un cation métallique, un cation ammonium quaternaire ou un cation phosphonium quaternaire), un groupe carboxamide (CONR₅R₆), un groupe acylamino (NR₅COR₇), un groupe acyle (COR₇), un groupe acyloxy (OCOR₇), ou un groupe sulfonamido (SO₂NR₅R₆),
ou (R₁ et R₂) ou (R₂ et R₃) ou (R₃ et R₄) sont joints entre eux avec 1 à 5 atomes de carbone, d'azote, de soufre et/ou d'oxygène pour former un ou des noyaux alicyliques ou aromatiques ;
déposer la dispersion de nanofils d'argent dans la solution de composé 1,2-diazine et de liant polymère sur un support transparent ; et
sécher le revêtement sur le support pour former un réseau aléatoire de nanofils d'argent.
